(19) Europäisches Patentamt
European Patent Office
Office européen des brevets

(11) **EP 3 224 677 B1**

(12) **EUROPÄISCHE PATENTSCHRIFT**

(45) Veröffentlichungstag und Bekanntmachung des Hinweises auf die Patenterteilung:
**10.10.2018 Patentblatt 2018/41**

(51) Int Cl.:
*G03F 7/20* (2006.01)     *G02B 5/09* (2006.01)
*G02B 19/00* (2006.01)     *G21K 1/06* (2006.01)

(21) Anmeldenummer: **15813278.7**

(22) Anmeldetag: **26.11.2015**

(86) Internationale Anmeldenummer:
**PCT/EP2015/077717**

(87) Internationale Veröffentlichungsnummer:
**WO 2016/083487 (02.06.2016 Gazette 2016/22)**

(54) **SPIEGEL, INSBESONDERE KOLLEKTORSPIEGEL FÜR MIKROLITHOGRAFIE**

MIRROR, IN PARTICULAR COLLECTOR MIRROR FOR MICROLITHOGRAPHY

MIROIR, EN PARTICULIER MIROIR COLLECTOR POUR MICRO-LITHOGRAPHIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.11.2014 DE 102014117453**

(43) Veröffentlichungstag der Anmeldung:
**04.10.2017 Patentblatt 2017/40**

(73) Patentinhaber: **Carl Zeiss SMT GmbH**
**73447 Oberkochen (DE)**

(72) Erfinder: **BAUER, Markus**
**73447 Oberkochen (DE)**

(74) Vertreter: **Witte, Weller & Partner Patentanwälte mbB**
**Postfach 10 54 62**
**70047 Stuttgart (DE)**

(56) Entgegenhaltungen:
WO-A2-2014/170093     DE-A1-102009 044 462
DE-A1-102010 063 530     US-A1- 2009 289 205

**Beschreibung**

Die vorliegende Anmeldung nimmt die Priorität der deutschen Patentanmeldung 10 2014 117 453.4 vom 27. November 2014 in Anspruch.

Die Erfindung betrifft einen Spiegel, insbesondere Kollektorspiegel, gemäß dem Oberbegriff des Anspruchs 1.

Ein solcher Spiegel ist aus WO 2014/170093 A2 bekannt.

Ein Kollektorspiegel wird in der EUV-Mikrolithografie eingesetzt, bei der es sich um ein Verfahren zur Herstellung und Strukturierung von Halbleiterbauteilen, integrierten Schaltkreisen sowie mikro- und nanosystemtechnischen Bauteilen handelt. In der Mikrolithografie werden auf einem Retikel vordefinierte Strukturen mit Hilfe von Belichtungsvorgängen auf ein Substrat, beispielsweise ein Siliziumsubstrat, abgebildet. Dabei ist das Substrat mit einem lichtempfindlichen Material, das allgemein als "Fotolack" bekannt ist, beschichtet. Während der Belichtung wechselwirkt das Belichtungslicht mit der Fotolackschicht, so dass sich die chemischen Eigenschaften der belichteten Bereiche der Fotolackschicht verändern. In einem anschließenden Entwicklungsschritt löst sich der Fotolack in den belichteten oder nichtbelichteten Bereichen, je nachdem, ob ein "positiver" oder ein "negativer" Fotolack verwendet wird. Schließlich werden die nicht durch den verbleibenden Fotolack bedeckten Bereiche der Substratoberfläche in einem Ätzverfahren, beispielsweise nasschemisches Ätzen, Plasmaätzen oder plasmaunterstütztes reaktives Ionenätzen, abgetragen. Somit entstehen die vordefinierten Strukturen des Retikels auf der bearbeiteten Substratoberfläche unter einem Projektionsmaßstab, der für das verwendete Mikrolithografiesystem, insbesondere eine Projektionsbelichtungsanlage, charakteristisch ist.

Die Leistungsfähigkeit der mikrolithografisch hergestellten Halbleiterbauteile bzw. integrierten Schaltkreise ist umso höher, je höher die Integrationsdichte der Strukturen in den Bauteilen ist. Mit anderen Worten besteht ein Bestreben darin, zunehmend feinere Strukturen auf das Substrat abzubilden. Die Untergrenze der in der optischen Lithografie erzielbaren Strukturgröße ist u.a. durch die Wellenlänge des verwendeten Belichtungslichtes bestimmt. Daher ist es vorteilhaft, möglichst kurzwelliges Belichtungslicht zu verwenden. Unter diesem Aspekt sind Projektionsbelichtungsanlagen bekannt, die extrem ultraviolettes (EUV) Licht als Belichtungslicht einsetzen, dessen Wellenlänge bei 13,5 nm liegt.

Das EUV-Licht wird von einer EUV-Lichtquelle erzeugt, bei der ein Plasma durch starke elektrische Entladungen (im Englischen: Gas Discharge Produced Plasma, GDPP) oder durch Fokussierung von Laserstrahlung (im Englischen: Laser-Produced Plasma, LPP) generiert wird. Im LPP-Verfahren wird ein Zinntröpfchen mit Pumplicht beschossen, wobei als Pumplicht üblicherweise infrarotes (IR) Licht verwendet wird. Das generierte Plasma enthält eine Vielzahl von Ladungsteilchen, beispielsweise Elektronen, die von energetisch hohen Zuständen in energetisch niedrigere Zustände fallen und dabei das erwünschte EUV-Licht emittieren. Des Weiteren kann aufgrund der im Plasma herrschenden hohen Temperatur, beispielsweise über 200,000 K, EUV-Licht in Form von Schwarzkörperstrahlung emittiert werden. Das erzeugte EUV-Licht propagiert in alle Raumrichtungen. Damit das EUV-Licht als Nutzstrahlen für den Belichtungsprozess nutzbar wird, muss ein möglichst großer Teil davon durch eine Sammeloptik, die unter dem Begriff "Kollektorspiegel" bekannt ist, in Richtung der Beleuchtungs- und Projektionsoptik gelenkt werden.

Aus dem Stand der Technik bekannte Kollektorspiegel weisen zwecks besserer Lichtfokussierung eine elliptische Spiegelfläche auf. Sie haben jedoch den Nachteil, dass mit zunehmender Dichte des Zinn-Plasmas die Plasmafrequenz sich stark erhöhen kann. In diesem Fall können neben den Nutzstrahlen auch Reststrahlen, d.h. elektromagnetische Strahlen aus einem vom EUV-Spektralbereich verschiedenen Restspektralbereich, welche für den Belichtungsprozess nicht nutzbar sind, an der Spiegelfläche des Kollektorspiegels reflektiert und auf den zweiten Brennpunkt fokussiert werden. Schließlich können die Reststrahlen in die Beleuchtungs- und Abbildungsoptik und gar bis zum Substrat gelangen. Zu den Reststrahlen gehören typischerweise hoch intensives IR-Licht und tief ultraviolettes (DUV) Licht. Die Reststrahlen verursachen einen erheblichen Wärmeeintrag auf die dem Kollektorspiegel nachgeordneten Optiken und damit eine nicht hinnehmbare Beeinträchtigung der optischen Eigenschaften dieser Optiken.

Um dieses Problem zu beheben, sind weitere elliptische Kollektorspiegel bekannt, die als Spectral-Purity-Filter (SPF) ausgebildet sind und ein binäres Gitter aufweisen. Das binäre Gitter dient dazu, das im ersten Brennpunkt emittierte EUV-Licht zu reflektieren und auf einen zweiten Brennpunkt zu fokussieren, wobei das fokussierte EUV-Licht durch eine im zweiten Brennpunkt befindliche Blende hindurchtritt, während das IR-Pumplicht dort blockiert wird. Dadurch wird das IR-Pumplicht unterdrückt.

Derartige Kollektorspiegel weisen jedoch den Nachteil auf, dass das binäre Gitter nur Reststrahlen von einer einzigen Wellenlänge wirksam unterdrücken kann, wobei dies auch nur dann möglich ist, wenn die Gitterparameter des binären Gitters, beispielsweise die Gitterperiode, in der Fertigung sehr genau kontrolliert wurden. Dabei entsteht zusätzlicher Fertigungsaufwand. Außerdem müssen die Reststrahlen eines breitbandigen Restspektralbereichs im Abbildungsstrahlengang unterdrückt werden, was den Fertigungsaufwand zusätzlich erhöht.

Des Weiteren weist das binäre Gitter Oberflächenrauheiten auf, deren Abmessungen im Bereich mittelwelliger Wellenlängen liegen. Derartige Oberflächenrauheiten sind auf Vibrationen und Genauigkeitsbegrenzungen der Vorrichtungen, die zur Herstellung des binären Gitters eingesetzt werden, zurückzuführen. Sie führen dazu, dass das erzeugte EUV-Licht nicht exakt auf den zweiten Brennpunkt des Kollektorspiegels, sondern auf einen aufgeweiteten Bereich um den zweiten Brennpunkt fokussiert wird. Der zweite Brennpunkt für das EUV-Licht wird auch als "Zwischenbrennpunkt (IF)" bezeichnet. Es kommt unerwünschterweise zu einer Verbreiterung des IFs. Um die Nutzstrahlen möglichst vollständig durch die Blende hindurchtreten zu lassen, muss die Blendenöffnung entsprechend vergrößert werden. Dies führt jedoch zu vermehrtem Durchlass der Reststrahlen.

Ein weiterer Nachteil solcher SPF-Kollektorspiegel besteht darin, dass der Kollektorspiegel mit einem sehr großen Durchmesser gebildet werden muss, um der Forderung nach großem Arbeitsabstand und kleiner IF-seitiger numerischer Apertur (NA) gleichzeitig Rechnung zu tragen. Je größer der Durchmesser des Kollektorspiegels, desto stärker variiert der Abbildungsmaßstab des Kollektorspiegels entlang der elliptischen Spiegelfläche. Der Abbildungsmaßstab ist definiert als das Verhältnis zwischen dem Abstand vom ersten Brennpunkt zum Strahleinfallspunkt auf der Spiegelfläche einerseits und dem Abstand vom Strahleinfallspunkt zum zweiten Brennpunkt andererseits. Dies führt unerwünschterweise zu einer Vergrößerung der Einhüllenden der Etendue, insbesondere im IF und/oder im Fernfeld. Auch die vorstehend genannten Oberflächenrauheiten begünstigen zusätzlich die Vergrößerung der Einhüllenden der Etendue.

Eine Vergrößerung der Einhüllenden der Etendue verursacht einen Verlust der erzeugten Nutzstrahlen, der sich bei extremen Beleuchtungsmodi eines EUV-Mikrolithografiesystems gravierend auf die Belichtungsqualität und/oder die Abbildungsqualität auswirkt.

Aus dem Stand der Technik sind auch weitere elliptische Kollektorspiegel bekannt, die ein Blazegitter aus einer Mehrzahl von Spiegelfacetten aufweisen. Zwar lassen sich die Nutzstrahlen hierdurch mit einer erhöhten Transmissionseffizienz fokussieren. Dennoch bleiben die mit den oben genannten Nachteilen zusammenhängenden Probleme, beispielsweise der Nutzstrahlenverlust, weitestgehend ungelöst.

Das eingangs genannte Dokument WO 2014/170093 A2 offenbart einen Kollektorspiegel mit einer Mehrzahl an reflektiven Oberflächen, wobei jede der reflektiven Oberflächen mit einem Teil eines Ellipsoids einer Mehrzahl von Ellipsoiden zusammenfällt, wobei die Mehrzahl an Ellipsoiden einen gemeinsamen ersten Brennpunkt und zweiten Brennpunkt aufweisen, wobei jede der reflektiven Oberflächen mit einem unterschiedlichen Ellipsoid der Mehrzahl an Ellipsoiden zusammenfällt, wobei die Mehrzahl an reflektiven Oberflächen dazu ausgebildet sind, Strahlung, die von dem ersten Zentrum ausgeht, zu empfangen und die Strahlung zu dem zweiten Brennpunkt zu reflektieren.

DE 10 2009 044 462 A1 offenbart ein optisches Element zum Filtern elektromagnetischer Strahlung, das eine Viellagenstruktur aufweist, die für die Reflexion von elektromagnetischer Strahlung im extrem ultravioletten Wellenlängenbereich ausgelegt ist, das eine Gitterstruktur aufweist, die für das Beugen von elektromagnetischer Strahlung im sichtbaren bis infraroten Wellenlängenbereich ausgelegt ist, und das Mittel aufweist, die für die Änderung der relativen Intensität und/oder Ausbreitungsrichtung von elektromagnetischer Strahlung im ultravioletten Wellenlängenbereich ausgelegt sind.

DE 10 2010 063 530 A1 offenbart ein Blendenelement mit einem Durchtrittsbereich für EUV-Strahlung und einem Abschattungsbereich der Strahlung in einem anderen Wellenlängenbereich. Das Blendenelement kann in einem optischen System für die EUV-Lithografie mit einem diffraktiven optischen Element, das EUV-Strahlung an einen anderen Ort ablenkt als Strahlung in einem anderen Wellenlängenbereich, sowie einer Laserplasma-Strahlungsquelle angeordnet sein.

US 2009/0289205 A1 offenbart eine EUV-Lichtquellenvorrichtung, die andere Strahlung als EUV-Strahlung aus dem Licht, das sie erzeugt, eliminiert.

Aus DE 10 2013 002 064 A1 ist ein Kollektorspiegel zum Sammeln von EUV-Strahlung bekannt, der ein optisches Gitter aufweist, das mehrere Gitterlemente aufweist. Die Gitterelemente können so ausgebildet sein, dass sie Abschnitte von Ellipsoiden darstellen.

Es ist eine Aufgabe der vorliegenden Erfindung, einen Spiegel, insbesondere für ein EUV-Mikrolithografiesystem, oder für den UV-Spektralbereich, bereitzustellen, der ein optisches Gitter mit einer optisch wirksamen Spiegelfläche aufweist, und der insgesamt über die Spiegelfläche hinweg einen zumindest näherungsweise konstanten Abbildungsmaßstab aufweist.

Erfindungsgemäß wird diese Aufgabe hinsichtlich des eingangs genannten Spiegels durch die Merkmale des Anspruchs 1 gelöst. Erfindungsgemäß sind die Facettenflächen in einer die optische Achse umfassenden Schnittebene auf mehren gedachten, entlang der optischen Achse voneinander verschobenen Ellipsenschalen angeordnet, deren gemeinsamen mathematischen Fokuspunkte mit dem ersten und dem zweiten Brennpunkt zusammenfallen, wobei die Facettenflächen auf die Ellipsenschalen so verteilt sind, dass die Facettenflächen an Schnittpunkten der Ellipsenschalen mit zumindest einem Abschnitt an der gedachten Kreisebene angeordnet sind, wobei für jeden Punkt auf der Kreislinie das Verhältnis aus dem Abstand des ersten Brennpunktes zu diesem Punkt und dem Abstand dieses Punktes zum zweiten Brennpunkt den gleichen Wert hat.

Diese Maßnahme hat den Vorteil, dass der Abbildungsmaßstab für die Spiegelfacetten, die dieser Anordnungsvorschrift genügen, konstant oder zumindest näherungsweise konstant ist. Licht aus dem ersten Brennpunkt wird von allen Spiegelfacetten, die dieser Anordnungsvorschrift genügen, scharf auf den zweiten Brennpunkt abgebildet. Der Kollektorspiegel kann so ausgestaltet sein, dass alle vorhandenen Spiegelfacetten diese Anordnungsvorschrift erfüllen, so dass der Abbildungsmaßstab der Spiegelfläche als Ganzes konstant ist.

Ein weiterer Vorteil dieser Maßnahme besteht darin, dass der Kollektorspiegel eine sphärische Oberfläche auf Substratseite aufweisen kann, was die Fertigung des Kollektorspiegels vorteilhaft vereinfacht.

Außerdem kann diese Ausgestaltung nicht nur für einen Kollektorspiegel, sondern vorteilhaft auch für einen abbildenden Spiegel innerhalb des EUV- Lithographiesystems, beispielsweise im Projektionsobjektiv, angewandt werden, weil ein solcher Spiegel eine sehr scharfe Abbildung ermöglicht. Die Spiegelfläche eines solchen Abbildungsspiegels kann insbesondere vollständig außerhalb der optischen Achse ("off-axis") angeordnet sein.

In der Geometrie wird die Menge aller Punkte, für die das Verhältnis der Abstände zu zwei vorgegebenen Punkten einen vorgegebenen Wert hat, auch als Appoloniuskreis bezeichnet. Gemäß dem vorliegenden Aspekt der Erfindung sind die Facettenflächen demnach nicht nur auf gegeneinander verschobene Ellipsenscharen angeordnet, sondern dies derart, dass die Facettenflächen zusätzlich auf einem Appoloniuskreis, mit dem ersten und zweiten Brennpunkt als Fixpunkte, angeordnet sind. Der Vorteil hierbei ist, dass die Substratoberfläche des Spiegels sphärisch sein kann, was die Fertigung des Spiegels deutlich vereinfacht. Aufgrund der Anordnung der auf die Ellipsenschalen entlang eines Appoloniuskreisabschnitts verteilten Facettenflächen bilden alle Facettenflächen den ersten Brennpunkt mit identischem Abbildungsmaßstab auf den zweiten Brennpunkt ab. Ein solcher Spiegel kann nicht nur als Kollektorspiegel eingesetzt werden, sondern auch allgemein als Abbildungsspiegel, weil der Spiegel durch die erfindungsgemäße Ausgestaltung eine sehr scharfe Abbildung vom ersten Brennpunkt in den zweiten Brennpunkt bewirkt.

In einer Weiterbildung sind die Fußpunkte der Spiegelfacetten an den Schnittpunkten angeordnet.

Hierdurch ergibt sich eine genaue Zuordnung jeder Facette zu den Schnittpunkten der Ellipsenschalen mit dem Appoloniuskreis, so dass sich für die Fertigung eine sehr genaue Anordnungsvorschrift der Spiegelfacetten ergibt.

Weiterhin ist es bevorzugt, wenn die Spiegelfläche vollständig außerhalb der optischen Achse angeordnet ist.

In dieser Ausgestaltung eignet sich der erfindungsgemäße Spiegel insbesondere als Abbildungsspiegel, beispielsweise in einem EUV-Mikrolithografiesystem, oder auch in einem UV-optischen System.

Das optische Gitter des erfindungsgemäßen Spiegels ist vorzugsweise ein Blazegitter oder oder eine Fresnelstruktur.

Jede Facettenfläche ist derart auf der Ellipsenschale angeordnet, dass sich die Facettenfläche entlang der Ellipsenschale oder tangential zur Ellipsenschale erstreckt. Da die mehreren gedachten Ellipsenschalen gemeinsame Fokuspunkte haben, bilden diese Ellipsenschalen eine gedachte konfokale Ellipsenschar. Jede Ellipsenschale entspricht mathematisch einer bezüglich der optischen Achse zumindest abschnittsweise rotationssymmetrischen, gedachten Ellipsoidenschale. Somit ist jede Facettenfläche räumlich betrachtet auf einer gedachten Ellipsoidenschale angeordnet, wobei die einzelnen gedachten Ellipsoidenschalen eine konfokale Ellipsoidenschar bilden. Die daraus resultierende Spiegelfläche verläuft entlang einer Bahnanordnung aus bezüglich der optischen Achse konzentrischen, in Richtung der optischen Achse voneinander beabstandeten Kreisbahnen, oder alternativ entlang einer Spiralbahn um die optische Achse.

Der erfindungsgemäße Kollektorspiegel ist somit in der Lage, Reststrahlen aus einem besonders breiten Restspektralbereich zu blockieren. Im Gegensatz zu bisherigen SPF-Gittern, insbesondere binären Gittern, die lediglich eine wirksame Reststrahlenunterdrückung einer einzigen Wellenlänge ermöglichen, wird mit Hilfe des erfindungsgemäßen Kollektorspiegels vorteilhafterweise eine breitbandige Reststrahlenunterdrückung erzielt.

Ferner weicht die Spiegelfläche des Kollektorspiegels von einer elliptischen Spiegelfläche ab. Bei elliptischen Kollektorspiegeln, d.h. Kollektorspiegeln mit einer elliptischen Spiegelfläche, variiert der Abbildungsmaßstab der Abbildung vom ersten Brennpunkt auf den zweiten Brennpunkt des Kollektorspiegels. Dies führt zu einer stark vergrößerten Einhüllenden der Etendue, insbesondere im IF und/oder im Fernfeld. Hieraus folgt ein hoher Nutzstrahlenverlust, da die Nutzstrahlen im IF nicht zu einem Strahlenbündel mit einem hinreichend kleinen Durchmesser fokussiert werden, um vollständig durch die Blende hindurchzutreten.

Im Gegensatz hierzu bildet der erfindungsgemäße Kollektorspiegel Nutzstrahlen vom ersten Brennpunkt auf den zweiten Brennpunkt ab, wobei die Variation des Abbildungsmaßstabs entlang der Spiegelfläche aufgrund der Anordnung der Facettenflächen auf der konfokalen Ellipsenschar zumindest reduziert ist. Die Vergrößerung der Einhüllenden der Etendue ist somit verringert. Dies ermöglicht selbst bei extremen Beleuchtungsmodi des EUV-Mikrolithografiesystems einen reduzierten Nutzstrahlenverlust. Das erzeugte EUV-Licht wird im IF zu einem Strahlbündel mit einem reduzierten Durchmesser fokussiert. Somit kann eine Blende mit einer kleineren Blendenöffnung verwendet werden. Dies erhöht den Anteil der von der Blende blockierten Reststrahlen.

Gleichzeitig sind die dem Kollektorspiegel nachgeordneten Optiken besser vor Verschmutzung durch die EUV-Lichtquelle geschützt. Vorteilhafterweise können Reinigungsgase, bspw. des H2-Gases, die zum Schutz der Optiken dienen, mit einem reduzierten Gasdruck eingesetzt werden, was neben einer Kostengünstigkeit die Transmission des EUV-Lichtes durch die Gasatmosphäre verbessert.

Die Spiegelfläche des Kollektorspiegels kann sich von einem Scheitelbereich bis zu einem Randbereich der gedachten Ellipsenschalen erstrecken. Ebenso ist es jedoch möglich, dass sich die Spiegelfläche nicht bis in den Scheitelbereich erstreckt, beispielsweise kann die Spiegelfläche im Scheitelbereich der gedachten Ellipsenschalen nicht vorhanden sein, beispielsweise dort eine Durchbrechung oder ein Loch aufweisen.

Weiterhin kann vorgesehen sein, dass eine randbereichsseitige Spiegelfacette eines benachbarten Spiegelfacettenpaares auf einer ersten Ellipsenschale angeordnet ist, wobei eine scheitelbereichsseitige Spiegelfacette des Spiegelfacettenpaares auf einer zur ersten Ellipsenschale benachbarten zweiten Ellipsenschale angeordnet ist, wobei die erste Ellipsenschale entlang der optischen Achse von der zweiten Ellipsenschale zum ersten Brennpunkt hin verschoben ist.

In dieser Ausgestaltung befindet sich mit anderen Worten von zwei benachbarten Spiegelfacetten die dem Randbereich der Spiegelfläche nähere Spiegelfacette auf einer gedachten Ellipsenschale, die dem ersten Brennpunkt näher ist als die gedachte Ellipsenschale, auf der sich die dem Scheitelbereich nähere Spiegelfacette der beiden Spiegelfacetten befindet. Wenn dies für alle Spiegelfacetten der Fall ist, kann beispielsweise die Spiegelfläche des Kollektorspiegels in der Schnittebene im Vergleich zu einer elliptischen Spiegelfläche zum Scheitel hin "durchgebeult" sein. D.h. gegenüber einer gedachten Ellipsenschale, die die Spiegelfläche des Kollektorspiegels im Randbereich überlappt, ist die Spiegelfläche des Kollektorspiegels im Scheitelbereich dann in Richtung von der gedachten Ellipsenschale weg gewölbt. Vorteilhafterweise kann der erfindungsgemäße Kollektorspiegel im Vergleich zu den bisherigen Kollektorspiegeln bei gleichbleibendem Arbeitsabstand mit einem kleineren Kollektordurchmesser und somit kompakter und/oder bei gleichbleibendem Kollektordurchmesser mit einem größeren Arbeitsabstand und somit strahlungsresistenter gebildet werden. Es ist jedoch ebenso möglich, dass die vorstehend genannte Ausgestaltung zu einer nicht "durchgebeulten" Spiegelfläche führen kann, wie später im Zusammenhang mit einer Ausführungsform des Kollektorspiegels mit konstantem Abbildungsmaßstab beschrieben wird. Die Begriffe "scheitelbereichsseitig" und "randbereichsseitig" sind relativ und in Bezug auf den Verlauf der Spiegelfläche zu verstehen und tragen die Bedeutung "vergleichsweise näher zum Scheitelbereich oder weiter vom Randbereich entfernt" bzw. "vergleichsweise näher zum Randbereich oder weiter vom Scheitelbereich entfernt".

Die mehreren gedachten Ellipsenschalen sind keine körperlichen Schalen des Kollektorspiegels, sondern dienen lediglich dazu, den Aufbau des Blazegitters mathematisch zu veranschaulichen. Des Weiteren ist der Begriff "Brennpunkt" im Rahmen dieser Erfindung als ein physikalisches bzw. optisches Merkmal des vorliegenden Kollektorspiegels zu verstehen, während der Begriff "Fokuspunkt" lediglich zur mathematischen Veranschaulichung der vorliegenden Erfindung dient.

In einer bevorzugten Ausgestaltung weist das Blazegitter einen Blazewinkel auf, um den die Facettenflächen jeweils lokal gegen eine Gitteroberfläche geneigt sind, wobei der Blazewinkel vom Randbereich zum Scheitelbereich hin steigt.

Im Rahmen dieser Ausgestaltung kann der Blazewinkel vom Randbereich zum Scheitelbereich hin kontinuierlich steigen, wobei diese Ausgestaltung auch den Fall umfasst, dass der Blazewinkel vom Randbereich zum Scheitelbereich hin abschnittsweise konstant ist. Bei facettierter Optik bzw. Gitteroptik treten Abschattungseffekte auf, bei denen ein Teil des spekularen Facettenreflexes, d.h. der an der Spiegelfläche reflektierten Nutzstrahlen, von einer benachbarten Spiegelfacette blockiert wird. Diese Abschattungseffekte hängen mit dem Blazewinkelverlauf zusammen. Vorteilhafterweise wird mithilfe dieser Maßnahme eine Minderung der Abschattungseffekte erreicht.

In einer weiteren bevorzugten Ausgestaltung ist auf den Ellipsenschalen jeweils nur eine Facettenfläche angeordnet.

Aufgrund der vereinfachten Zuordnung zwischen Facettenflächen und Ellipsenschalen wird der Designaufwand für das Blazegitter reduziert, so dass der erfindungsgemäße Kollektorspiegel besonders einfach und damit einhergehend besonders kostengünstig herstellbar ist.

In einer weiteren bevorzugten Ausgestaltung sind die Ellipsenschalen entlang der optischen Achse im Wesentlichen äquidistant voneinander beabstandet.

Aufgrund der vereinfachten geometrischen Form der konfokalen Ellipsenschar lässt sich das Blazegitter ohne hohen rechnerischen Aufwand konstruieren. Dies führt vorteilhafterweise zu erhöhter Herstellungseinfachheit und Kostengünstigkeit.

In einer weiteren bevorzugten Ausgestaltung weisen zumindest zwei Spiegelfacetten einen Brennweitenkehrwert von zumindest annähernd 0 oder die zumindest zwei Spiegelfacetten weisen einen gleichen Brennweitenkehrwert auf.

Mit Hilfe dieser Maßnahme können mehrere Spiegelfacetten mit der gleichen Brennweite ausgebildet und/oder eingesetzt werden. Der erfindungsgemäße Kollektorspiegel lässt sich dadurch mit geringerem Aufwand herstellen. Vorzugsweise ist der Brennweitenkehrwert bei allen Spiegelfacetten verschwindend klein bzw. gleich Null. Dies führt zu einem vorteilhafterweise reduzierten Steigungsfehler der Facettenflächen und/oder der Facettenränder. Außerdem können die Facettenflächen als plane Facettenflächen ausgebildet werden, was die Herstellungseinfachheit des Kollektorspiegels erhöht.

In einer weiteren bevorzugten Ausgestaltung weist das Blazegitter ein Beugungsgitter zum Beugen der Reststrahlen auf, wobei die an der Spiegelfläche reflektierten Nutzstrahlen um zumindest das Zweifache des Blazewinkels von den gebeugten Reststrahlen der nullten Beugungsordnung abgelenkt und/oder zwischen den gebeugten Reststrahlen der nullten und der ersten Beugungsordnung verlaufen.

Der spekulare Facettenreflex der einfallenden Nutzstrahlen verläuft getrennt von den gebeugten Reststrahlen. Somit werden die Nutzstrahlen allein auf den Zwischenbrennpunkt (IF) fokussiert. Vorteilhafterweise werden die Reststrahlen verschiedener Beugungsordnungen effektiv unterdrückt, so dass durch die Blende im Wesentlichen nur die Nutzstrahlen hindurchtreten.

In einer weiteren bevorzugten Ausgestaltung umfasst der Restspektralbereich einen infraroten Spektralbereich, wobei die nullte und die erste Beugungsordnung auf die gebeugten Reststrahlen einer minimalen Wellenlänge des Restspektralbereichs bezogen sind.

Der spekulare Facettenreflex der einfallenden Nutzstrahlen verläuft getrennt vom gebeugten IR-Licht der nullten und der ersten Beugungsordnung und kann somit alleine durch die Blendenöffnung hindurchtreten, ohne mit dem IR-Licht der niedrigsten Beugungsordnungen überlagert zu sein. Vorteilhafterweise wird das für den Belichtungsprozess unerwünschte, hochintensive IR-Licht dadurch besonders effektiv unterdrückt.

In einer weiteren bevorzugten Ausgestaltung weisen die Facettenflächen in der Schnittebene jeweils eine Facettenlänge auf, wobei zumindest zwei Facettenlängen verschieden sind und/oder die Facettenlänge eine maximale Facettenlänge nicht überschreitet, die in Abhängigkeit von einer minimalen Wellenlänge des Restspektralbereichs gewählt ist.

Mithilfe entlang der Spiegelfläche variierender Facettenlänge kann der Kollektorspiegel besonders flexibel gestaltet werden, um vielfältige praktische Anforderungen in der EUV-Mikrolithografie zu erfüllen. Des Weiteren unterdrückt der Kollektorspiegel kurzwellige Reststrahlen besonders effektiv.

In einer weiteren bevorzugten Ausgestaltung liegt die Facettenlänge im Bereich von 10 $\mu$m bis 200 $\mu$m.

In dieser Ausgestaltung ist die Facettenlänge im Vergleich zur Wellenlänge des EUV-Lichtes hinreichend groß, so dass Beugungseffekte in Bezug auf das EUV-Licht weitestgehend unterdrückt sind. Das reflektierte EUV-Licht verläuft im Wesentlichen in einer Richtung und kann somit besonders effektiv auf den zweiten Brennpunkt fokussiert werden. Gleichzeitig ist die Facettenlänge hinreichend kurz, so dass Beugungseffekte in Bezug auf das IR- und das DUV-Licht nicht vernachlässigt werden können.

In einer weiteren bevorzugten Ausgestaltung weist das Blazegitter eine Oberflächenrauheit im Bereich von 0 bis 0,2 nm auf.

Die Nutzstrahlen können somit mit erhöhter Genauigkeit auf den zweiten Brennpunkt fokussiert werden. Die Verbreiterung des Zwischenbrennpunktes wird reduziert, so dass Blenden mit verringerter Blendenöffnung zwecks effektiveren Unterdrückens der Reststrahlen verwendet werden können.

In einer weiteren bevorzugten Ausgestaltung weist das Blazegitter eine Kantenverrundung mit einem Radius im Bereich von 0 bis 1 $\mu$m auf.

Die Kantenverrundung des erfindungsgemäßen Kollektorspiegels ist hinreichend reduziert, so dass die Genauigkeit der Nutzstrahlenfokussierung erhöht ist. Blenden mit zusätzlich verringerter Blendenöffnung können verwendet werden, was die Beaufschlagung der Beleuchtungs- und der Projektionsoptik mit den Reststrahlen reduziert.

In einer weiteren bevorzugten Ausgestaltung ist das Blazegitter aus einem Gitterwerkstück in einem Ultrapräzisionsdrehverfahren hergestellt, bei dem ein spanabhebendes Werkzeug relativ zum Gitterwerkstück entlang einer Spiralbahn und/oder einer Bahnanordnung aus konzentrischen Kreisen gefahren wird.

Das Blazegitter ist hinsichtlich Verlauf des Blazewinkels und/oder der Facettenlänge mit erhöhter Präzision gebildet. Bei einer spiralförmigen Relativbewegung des spanabhebenden Werkzeugs, beispielsweise eines Diamantwerkzeugs, in Bezug auf das Gitterwerkstück ist ein abwechselndes An- und Abfahren des Werkzeugs nicht erforderlich, so dass die Strukturierungszeiten vorteilhafterweise besonders kurz sind. Ferner ist der Einfluss von Vibrationen des Diamantwerkzeugs auf die Gitterqualität verringert.

In einer weiteren bevorzugten Ausgestaltung sind die Spiegelfacetten jeweils in einem einzigen Spanvorgang hergestellt, bei dem die Spiegelfläche von einer der Spiegelfläche zugewandten Druckseite des spanabhebenden Werkzeugs erfasst wird.

Die Bearbeitungszeit der Spiegelfacetten wird hierdurch kürzer als bei herkömmlichen Spiegelfacetten. Die Facettenflächen können als "Abbild" der Druckseite, beispielsweise einer planen Druckseite, gebildet werden, so dass die Oberflächenqualität der Facettenflächen im Wesentlichen nur von der Beschaffenheit der Druckseite abhängt. Der Steigungsfehler der Facettenflächen wird vorteilhafterweise reduziert.

In einer weiteren bevorzugten Ausgestaltung sind die Facettenflächen in einem dem Ultrapräzisionsdrehverfahren nachgeschalteten Glättverfahren unter Verwendung von Ionenstrahlen und/oder zumindest einem Flüssigfilm oberflächenbearbeitet.

Die Oberflächenrauheit der Facettenflächen wird hierdurch zusätzlich reduziert. Des Weiteren sind die hiermit oberflächenbearbeiteten Facettenflächen besonders gleichmäßig.

In einer weiteren bevorzugten Ausgestaltung sind die Facettenflächen mit einem Schichtstapel aus mehreren alternierenden Einzelschichten aus Molybdän und Silizium (MoSi) beschichtet, wobei eine Schichtdicke jeder Einzelschichten in Abhängigkeit von einem lokalen Strahleinfallswinkel in Bezug auf die einzelnen Facettenflächen gewählt ist.

Mit Hilfe der MoSi-Schichten sind die Reflexionseigenschaften der einzelnen Spiegelfacetten verbessert. Das EUV-Licht wird aufgrund der gewählten Schichtdicke der MoSi-Schichten vorteilhafterweise mit einer erhöhten, für alle Spiegelfacetten gleichmäßigen Präzision auf den zweiten Brennpunkt fokussiert.

Weitere Vorteile und Merkmale ergeben sich aus der nachfolgenden Beschreibung und der beigefügten Zeichnung.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen. Die Erfindung wird durch die Ansprüche definiert.

Ausführungsbeispiele der Erfindung sind in der Zeichnung dargestellt und werden mit Bezug auf diese hiernach beschrieben. Es zeigen:

Fig. 1     eine schematische Schnittdarstellung eines Kollektorspiegels;

Fig. 2     eine schematische Schnittdarstellung eines Kollektorspiegels gemäß dem Stand der Technik;

Fig. 3A-B     eine schematische Darstellung zur Erläuterung der Wirkungen unterschiedlicher Spiegelflächenverläufe;

Fig. 4     eine schematische Darstellung zur Erläuterung der räumlichen Trennung reflektierter Nutzstrahlen von gebeugten Reststrahlen mittels des Kollektorspiegels in Fig. 1;

Fig. 5     ein schematisches Diagramm einer Intensitätsverteilung im Fernfeld als Funktion der Raumfrequenz bzw. der Beugungsordnung;

Fig. 6A     eine schematische Darstellung zur Erläuterung des Verlaufs des Blazewinkels;

Fig. 6B     eine schematische Darstellung zur Erläuterung der Abschattungseffekte zwischen benachbarten Spiegelfacetten;

Fig. 7A-B     eine illustrative Darstellung eines Verfahrens zur Herstellung des Kollektorspiegels in Fig. 1;

Fig. 8A-B     eine illustrative Darstellung einer Bewegungsbahn eines spanabhebenden Werkzeugs relativ zu einem Gitterwerkstück im Verfahren in Fig. 7A-B;

Fig. 9     ein schematisches Diagramm eines Steigungsfehlers als Funktion einer Radius-Koordinate; und

Fig. 10 und 11     eine schematische Schnittdarstellung eines Spiegels gemäß einem Ausführungsbeispiel.

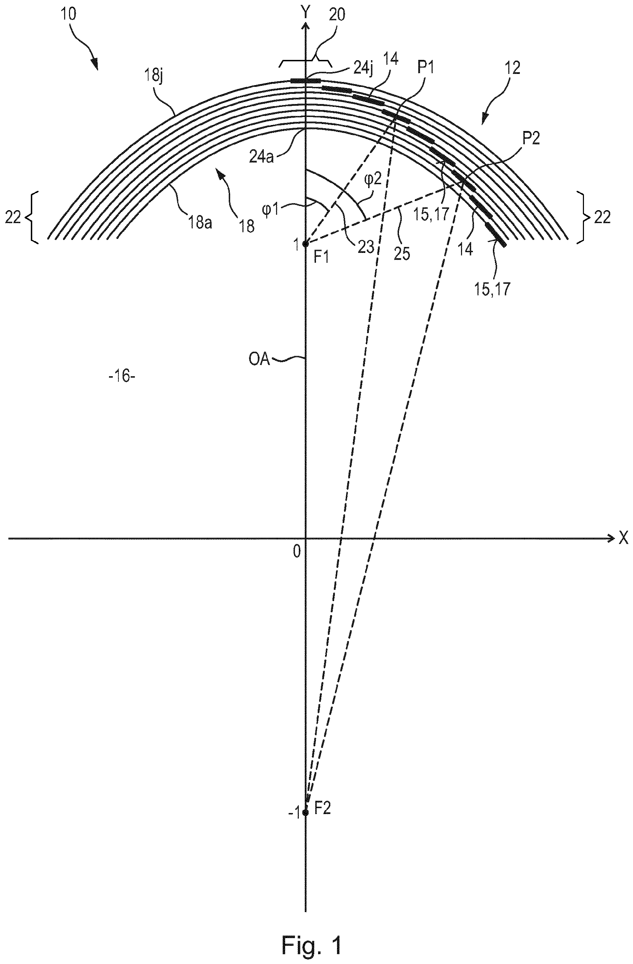

Fig. 1 zeigt in einer schematischen Schnittdarstellung einen im Allgemeinen mit dem Bezugszeichen 10 versehenen Kollektorspiegel. Der Kollektorspiegel 10 dient zum Sammeln bzw. Fokussieren von EUV-Licht in einer EUV-Lichtquelle eines EUV-Mikrolithografiesystems und weist ein optisches Gitter 12 auf, das nachfolgend als Blazegitter bezeichnet wird. Das Blazegitter 12 weist mehrere Spiegelfacetten 14 auf, die jeweils eine Facettenfläche 15 aufweisen. Die Facettenflächen 15 der Spiegelfacetten 14 bilden zusammen eine sägezahnförmige, "geblazte" Spiegelfläche 17.

Die Facettenflächen 15 sind in einer Schnittebene 16 auf mehreren gedachten Ellipsenschalen 18a-j angeordnet. In Fig. 1 sind aus Übersichtlichkeitsgründen nur die innerste Ellipsenschale 18a und die äußerste Ellipsenschale 18j jeweils mit einem Bezugszeichen versehen. Die Facettenflächen 15 sind jeweils auf einer der mehreren gedachten Ellipsenschalen 18a-j angeordnet, wobei sich die Facettenflächen 15 entlang oder tangential zu der jeweiligen Ellipsenschale 18a-j erstrecken. Die Ellipsenschalen 18a-j besitzen zwei gemeinsame Fokuspunkte, die mit einem ersten Brennpunkt F1 und einem zweiten Brennpunkt F2 des Kollektorspiegels zusammenfallen. Somit bilden die Ellipsenschalen 18a-j eine gedachte konfokale Ellipsenschar 18. Die Spiegelfläche 17 des Blazegitters 12 erstreckt sich in dem gezeigten Ausführungsbeispiel in der Schnittebene 16 von einem Scheitelbereich 20 bis zu einem Randbereich 22 der konfokalen Ellipsenschar 18. Die Spiegelfläche 17 kann im Scheitelbereich 20 jedoch auch nicht vorhanden sein, und der Kollektorspiegel 10 kann dort eine Durchbrechung oder ein Loch aufweisen.

In der Schnittdarstellung von Fig. 1 sind die Facettenflächen 15 zwecks Vereinfachung nur auf einer Hälfte der Ellipsenschalen 18a-j gezeigt. Räumlich betrachtet ist das Blazegitter 12 zumindest abschnittsweise rotationssymmetrisch um eine optische Achse OA ausgebildet, wobei die optische Achse OA durch den ersten Brennpunkt F1 und den zweiten Brennpunkt F2 definiert ist. Dabei kann die Spiegelfläche 17 entlang einer Spiralbahn um die optische Achse OA verlaufen. Alternativ kann die Spiegelfläche 17 entlang mehrerer bezüglich der optischen Achse OA konzentrischer, in Richtung der optischen Achse OA voneinander beabstandeter Kreisbahnen verlaufen.

In Fig. 1 ist zur mathematischen Veranschaulichung der konfokalen Ellipsenschar 18 ein kartesisches Koordinatensystem gezeigt, dessen Y-Achse mit der optischen Achse OA zusammenfällt und dessen Ursprung der Mittelpunkt zwischen dem ersten und dem zweiten Brennpunkt F1, F2 ist. Zwecks Vereinfachung sind alle Koordinaten auf die Brennweite, d.h., den Abstand vom Ursprung zum Brennpunkt F1, F2, normiert. Wie in Fig. 1 zu sehen ist, schneidet jede der gedachten Ellipsenschalen 18a-j die Y-Achse jeweils in einem zugehörigen Längsachsenschnittpunkt bzw. Scheitelpunkt 24a-j, wobei aus Übersichtlichkeitsgründen nur der innerste und der äußerste Längsachsenschnittpunkt 24a, j jeweils mit einem Bezugszeichen versehen sind. Den Längsachsenschnittpunkten 24a-j sind die Koordinaten (0, yn) zugeordnet. Hier bezieht sich der Index n=a, b, c, ..., j auf die Nummerierung der einzelnen Ellipsenschalen 18a-j. Jede gedachte Ellipsenschale 18a-j ist ein Teil einer zugehörigen Ellipse, die die X-Achse in einem Querachsenschnittpunkt mit den Koordinaten (xn, 0) schneidet, was jedoch in Fig. 1 aus Gründen der Vereinfachung nicht gezeigt ist. Den auf jeder gedachten Ellipsenschale 18a-j liegenden Punkten können somit die Koordinaten (x, y) zugeordnet werden, die der folgenden Ellipsenfunktion gehorchen:

$$(x/x_n)^2 + (y/y_n)^2 = 1 \quad (1)$$

Für die Koordinaten des Längsachsenschnittpunktes und des Querachsenschnittpunktes jeder Ellipse bzw. jeder Ellipsenschale gilt folgende Beziehung:

$$(y_n)^2 - (x_n)^2 = 1 \quad (2)$$

Dadurch, dass die Facettenflächen 15 auf den Ellipsenschalen 18a-j angeordnet sind, ist der Kollektorspiegel 10 in der Lage, elektromagnetische Nutzstrahlen eines EUV-Spektralbereichs, die vom ersten Brennpunkt F1 ausgehen und zur Spiegelfläche 17 des Kollektorspiegels 10 gelangen, an zumindest einer der Facettenflächen 15 zu reflektieren und auf den zweiten Brennpunkt F2 zu fokussieren. In Fig. 1 sind zwei Nutzstrahlen 23, 25 beispielhaft gezeigt, die unter einem Winkel φ1, φ2 zur optischen Achse OA auf einen jeweiligen Strahleinfallspunkt P1, P2 auf der jeweiligen Facettenfläche 15 eintreffen. Dort werden die Nutzstrahlen 23, 25 reflektiert und in Richtung des zweiten Brennpunktes F2 gelenkt. Somit werden die Nutzstrahlen 23, 25 auf den zweiten Brennpunkt F2 fokussiert. Die fokussierten Nutzstrahlen 23, 25 in Fig. 1 sind aus Gründen der Vereinfachung als Einzellinien dargestellt, wobei im Allgemeinen die Spiegelfläche 17 mit einem Strahlenbündel endlichen Durchmessers erfasst wird.

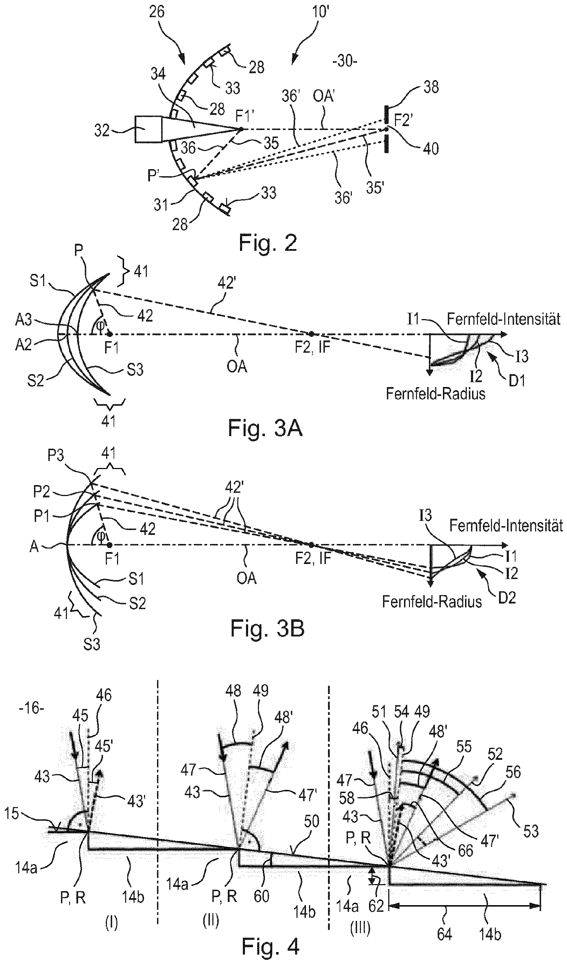

Der Kollektorspiegel 10 ist gleichzeitig in der Lage, elektromagnetische Reststrahlen eines vom EUV-Spektralbereich verschiedenen Restspektralbereichs, die ebenfalls vom ersten Brennpunkt F1 ausgehen, nach dem Reflektieren bzw. Beugen am Blazegitter 12 in zumindest eine Richtung zu lenken, die von der Strahlausfallsrichtung der Nutzstrahlen 23, 25 abweicht, so dass die Reststrahlen durch eine im zweiten Brennpunkt F2 befindlichen Blende 38, die in Fig. 2 gezeigt ist, blockiert werden.

In Fig. 1 sind neun Spiegelfacetten 14 gezeigt, wobei auf jeder der Ellipsenschalen 18a-j nur eine Facettenfläche 15 angeordnet ist. Die Anzahl der Spiegelfacetten 14 kann jedoch kleiner oder größer als neun sein. Außerdem kann die Anzahl der auf einer Ellipsenschale 18a-j angeordneten Facettenflächen 15 größer als eins sein. In Fig. 1 sind ferner die Ellipsenschalen 18a-j entlang der optischen Achse OA im Wesentlichen äquidistant voneinander beabstandet. Somit sind die Längsachsenschnittspunkte 24a-j der Ellipsenschalen 18a-j ebenfalls äquidistant voneinander beabstandet.

Die Facettenflächen 15 sind ferner so angeordnet, dass die Ellipsenschale 18a-j, auf der die Facettenfläche 15 der randbereichsseitigen Spiegelfacette 14 jedes benachbarten Spiegelfacettenpaares angeordnet ist, von der Ellipsenschale 18a-j, auf der die Facettenfläche 15 der scheitelbereichseitigen Spiegelfacette 14 desselben Spiegelfacettenpaares angeordnet ist, entlang der optischen Achse OA zum ersten Brennpunkt F1 hin verschoben ist. Die daraus resultierende Spiegelfläche 17 ist in der Schnittebene 16 im Vergleich zur innersten Ellipsenschale 18a zum äußersten Scheitelpunkt 24j hin gewölbt bzw. "durchgebeult". Gleichzeitig ist die Spiegelfläche 17 im Vergleich zur äußersten Ellipsenschale 18j im Randbereich 22 zur innersten Ellipsenschale 18a hin gekrümmt. Nachfolgend wird die Spiegelfläche 17 zur Unterscheidung von einer elliptischen oder einer sphärischen Spiegelfläche als "durchgebeulte Spiegelfläche" bezeichnet.

Aufgrund der besonderen Anordnung der Facettenflächen 15 können breitbandige Reststrahlen unterdrückt werden. Im Gegensatz hierzu können die bisherigen Kollektorspiegel, insbesondere Kollektorspiegel mit einem binären Gitter, nur Reststrahlen einer einzigen Wellenlänge unterdrücken.

Fig. 2 zeigt einen beispielhaften Kollektorspiegel 10' gemäß dem Stand der Technik, mit einem binären Gitter 26, wobei das binäre Gitter 26 mehrere Spiegelfacetten 28 aufweist. Der Kollektorspiegel 10' weist eine elliptische Spiegelfläche 33 auf, wobei die Spiegelfacetten 28 in der hier gezeigten Schnittebene 30 auf einer einzigen Ellipsenschale 31 angeordnet sind. Mit von einer Pumplichtquelle 32 erzeugtem IR-Pumplicht 34 wird ein Target, das in einem ersten Brennpunkt F1' angeordnetes ist, beschossen. Als Target wird beispielsweise ein Zinntröpfchen verwendet. Hierdurch wird ein Plasma, insbesondere ein Zinn-Plasma generiert, bei dessen elektronischen Übergängen EUV-Licht erzeugt wird. Das erzeugte EUV-Licht trifft als Nutzstrahl 35 auf einen Strahleinfallspunkt P' auf einer der Spiegelfacetten 28 ein, an der der Nutzstrahl 35 reflektiert und auf einen zweiten Brennpunkt F2' fokussiert wird. Im zweiten Brennpunkt F2' ist eine Blende 38 angeordnet, durch deren Blendenöffnung 40 der reflektierte Nutzstrahl 35' hindurchtritt. Gleichzeitig wird ein einfallender Reststrahl 36, der dem einfallenden Nutzstrahl 35 überlagert ist, an der Spiegelfacette 28 gebeugt. Der gebeugte Reststrahl 36' verläuft in zwei Richtungen außerhalb des reflektierten Nutzstrahls 35' und wird von der Blende 38 blockiert. Auf diese Weise werden Reststrahlen durch den Kollektorspiegel 10' im Zusammenwirken mit der Blende 38 unterdrückt.

Im Gegensatz zum elliptischen Kollektorspiegel 10' in Fig. 2 sind die Facettenflächen 15 des "durchgebeulten" Kollektorspiegels 10 in Fig. 1 nicht auf einer einzigen Ellipsenschale, sondern auf einer konfokalen Ellipsenschar 18 angeordnet. Neben einer breitbandigen Reststrahlenunterdrückung ermöglicht der Kollektorspiegel 10 eine zumindest reduzierte Änderung des Abbildungsmaßstabs entlang der Spiegelfläche 17, so dass die Vergrößerung der Einhüllenden der Etendue im IF und im Fernfeld reduziert ist.

Fig. 3A zeigt drei schematische Spiegelflächenverläufe S1-S3. Der erste Verlauf S1 entspricht einer sphärischen Spiegelfläche, der zweite Verlauf S2 einer "durchgebeulten" Spiegelfläche und der dritte Verlauf S3 einer elliptischen Spiegelfläche. Ein Nutzstrahl 42 tritt vom ersten Brennpunkt F1 ausgehend unter dem Winkel φ zur optischen Achse OA auf den Strahleinfallspunkt P auf einem der drei Spiegelflächenverläufe S1-S3 ein und wird von dort aus zum zweiten Brennpunkt F2 reflektiert. In Fig. 3A ist aus Gründen der Vereinfachung nur der Strahleinfall auf den elliptischen Spiegelflächenverlauf S3 gezeigt.

Die Intensität eines durch die jeweilige Spiegelfläche fokussierten Nutzstrahls 42' im Fernfeld als Funktion von einem Fernfeld-Radius, d.h. dem Abstand zwischen dem Ort der Strahlintensitätsmessung und der optischen Achse OA, ist im Diagramm D1 durch I1, I2, I3 gezeigt. Im Vergleich zur Intensitätsverteilung I1 der elliptischen Spiegelfläche ändert sich die Intensitätsverteilung I2 der "durchgebeulten" Spiegelfläche mit veränderlichem Fernfeld-Radius schwach. Mit anderen Worten ist die Intensitätsverteilung I2 der "durchgebeulten" Spiegelfläche verglichen zur elliptischen Spiegelfläche homogener. Dies ist auf eine reduzierte Vergrößerung der Einhüllenden der Etendue und schließlich auf die reduzierte Variation des Abbildungsmaßstabs des "durchgebeulten" Kollektorspiegels im Vergleich zum elliptischen Kollektorspiegel zurückzuführen.

Der Abbildungsmaßstab V(φ) ist, wie oben bereits eingeführt, definiert als das Verhältnis zwischen dem Abstand dF1-P(φ) vom ersten Brennpunkt F1 zum Strahleinfallspunkt P einerseits und dem Abstand dP(φ)-F2 vom Strahleinfallspunkt P zum zweiten Brennpunkt F2 andererseits:

$$V(\varphi) := dF1\text{-}P(\varphi) \,/\, dP(\varphi)\text{-}F2 \quad (3)$$

Die Abhängigkeit des Abbildungsmaßstabs V(φ) vom Winkel φ ist je nach Art der Spiegelfläche unterschiedlich. Bei sphärischen Spiegelflächen (S1) verhält sich der Abbildungsmaßstab V(φ) nahezu unabhängig vom Winkel φ, während bei elliptischen Spiegelflächen (S3) der Abbildungsmaßstab V(φ) mit variierendem Winkel φ stark variiert. Bei der "durchgebeulten" Spiegelfläche, variiert der Abbildungsmaßstab V(φ) zwar mit Winkel φ, jedoch weniger ausgeprägt als bei elliptischen Spiegelflächen.

Die Spiegelflächenverläufe S1-S3 münden in gleichen Enden 41. Dies bedeutet, dass die zu diesen Verläufen S1-S3 zugehörigen Kollektorspiegel im Wesentlichen den gleichen Kollektorspiegeldurchmesser besitzen. Des Weiteren ist der Längsachsenschnittpunkt A2 des "durchgebeulten" Verlaufs S2 weiter vom ersten Brennpunkt F1 entfernt als der Längsachsenschnittpunkt A3 des elliptischen Verlaufs S3. Der Abstand zwischen dem Längsachsenschnittpunkt A2, A3 und dem ersten Brennpunkt F1 ist bekannt als der "Arbeitsabstand" eines Kollektorspiegels. Je größer der Arbeitsabstand, desto weiter ist der Kollektorspiegel vom hoch energetischen Plasma beabstandet, was eine erhöhte Wärme- und Strahlresistenz verspricht. Dies bedeutet, dass der "durchgebeulte" Kollektorspiegel gegenüber einem elliptischen Kollektorspiegel mit gleichem Durchmesser weniger wärme- und strahlbelastet ist.

Bei den in Fig. 3B gezeigten schematischen Spiegelflächenverläufen S1-S3 fallen die Längsachsenschnittpunkte A zusammen. Die zu diesen Verläufen S1-S3 zugehörigen Kollektorspiegel besitzen daher den gleichen Arbeitsabstand. Gleichzeitig weist der "durchgebeulte" Verlauf S2 eine kleinere Erstreckung zwischen seinen beiden Enden 41 als der elliptische Verlauf S3. Der zum Verlauf S2 zugehörige "durchgebeulte" Kollektorspiegel weist somit einen geringeren Durchmesser auf als der zum Verlauf S3 zugehörige elliptische Kollektorspiegel. Je geringer der Durchmesser, desto kompakter und gewichtsarmer ist der Kollektorspiegel. Dies bedeutet, dass der "durchgebeulte" Kollektorspiegel gegenüber einem elliptischen Kollektorspiegel mit gleichem Arbeitsabstand kompakter und gewichtsarmer gebildet werden kann.

Fig. 4 zeigt eine schematische Darstellung zur Erläuterung der räumlichen Trennung reflektierter Nutzstrahlen von Reststrahlen mittels des Kollektorspiegels 10 in Fig. 1. Fig. 4 enthält drei Bereiche (I)-(III), in denen jeweils ein Übergang zwischen zwei benachbarten Spiegelfacetten 14a, b eines Blazegitters 12 gezeigt ist, wobei die Bereiche (II) und (III) denselben Übergang des Bereichs (I) zeigen.

Im Bereich (I) tritt ein einfallender Nutzstrahl 43 unter einem Nutzstrahleinfallswinkel 45 auf den Strahleinfallspunkt P ein, wobei der Nutzstrahleinfallswinkel 45 auf eine zur Facettenfläche 15 senkrechte Facettennormale 46 bezogen ist, und wobei der Strahleinfallspunkt P mit einem Anschlusspunkt R zwischen den benachbarten Spiegelfacetten 14a, b zusammenfällt. Der einfallende Nutzstrahl 43 wird an der Facettenfläche 15 reflektiert. Der reflektierte Nutzstrahl 45' verläuft unter einem Nutzstrahlausfallswinkel 45' bezogen auf die Facettennormale 42, wobei der Nutzstrahlausfallswinkel 45' gleich dem Nutzstrahleinfallswinkel 45 ist. Der an der Facettenfläche 15 reflektierte Nutzstrahl 45' wird als "spekularer Facettenreflex" bezeichnet.

Im Bereich (II) tritt ein einfallender Reststrahl 47, der dem einfallenden Nutzstrahl 43 überlagert ist, unter einem Reststrahleinfallswinkel 48 auf den Strahleinfallspunkt P ein, wobei der Reststrahleinfallswinkel 48 auf eine Gitteroberflächennormale 49, die senkrecht zu einer Gitteroberfläche 50 zeigt, bezogen ist. Der Verlauf der Gitteroberfläche 48 entspricht in der hier gezeigten Schnittebene 16 einer Verbindungslinie der Anschlusspunkte R zwischen den benachbarten Spiegelfacetten 14a, b. Im Strahleinfallspunkt P treten wegen der sehr viel größeren Wellenlänge des Reststrahls 47 Beugungseffekte auf. Der unter der Beugungsordnung 0 gebeugte Reststrahl 47' verläuft unter einem nullten Reststrahlausfallswinkel 48' bezogen auf die Gitteroberflächennormale 46, wobei der nullte Reststrahlausfallswinkel 48' dem Reststrahleinfallswinkel 44 gleich ist. Ferner ist hier ein Blazewinkel 60 für die Spiegelfacette 14b gezeigt, d.h. der Winkel, um den die Facettenfläche 15 der Spiegelfacette 14b gegen die Gitteroberfläche 50 geneigt ist.

Wie im Bereich (III) gezeigt ist, weist die Spiegelfacette 14b eine Stufenhöhe 62 und eine Facettenlänge 64 auf, wobei das Verhältnis zwischen der Stufenhöhe 62 und der Facettenlänge 64 dem Tangens des Blazewinkels 60 entspricht.

Im Bereich (III) sind neben den in den Bereichen (I) und (II) gezeigten Strahlenverläufen die jeweils unter den Beugungsordnungen 1, -1 und -2 gebeugten Reststrahlen 51, 52, 53 zu sehen, die unter einem ersten, zweiten bzw. dritten Reststrahlausfallswinkel 54, 55, 56, bezogen auf die Gitteroberflächennormale 49, verlaufen. Die Gitteroberflächennormale 49 und die Facettennormale 46 schließen einen Winkel 58 ein, der dem Blazewinkel 60 gleich ist. Des Weiteren ist der unter der Beugungsordnung 0 gebeugte Reststrahl 47' vom reflektierten Nutzstrahlen 43' um einen Ablenkwinkel 66 vom abgelenkt. Vorzugsweise beträgt der Ablenkwinkel 66 zumindest das Zweifache des Blazewinkels 60. Gleichzeitig verläuft der reflektierte Nutzstrahl 43', vorzugsweise mittig, zwischen den gebeugten Reststrahlen der Beugungsordnung 0 einerseits und dem gebeugten Reststrahl 51 der Beugungsordnung 1 andererseits. Weiter vorzugsweise beziehen sich die Beugungsordnungen 0, 1, -1 und/oder -2 auf eine minimale Wellenlänge λmin eines IR-Spektralbereiches.

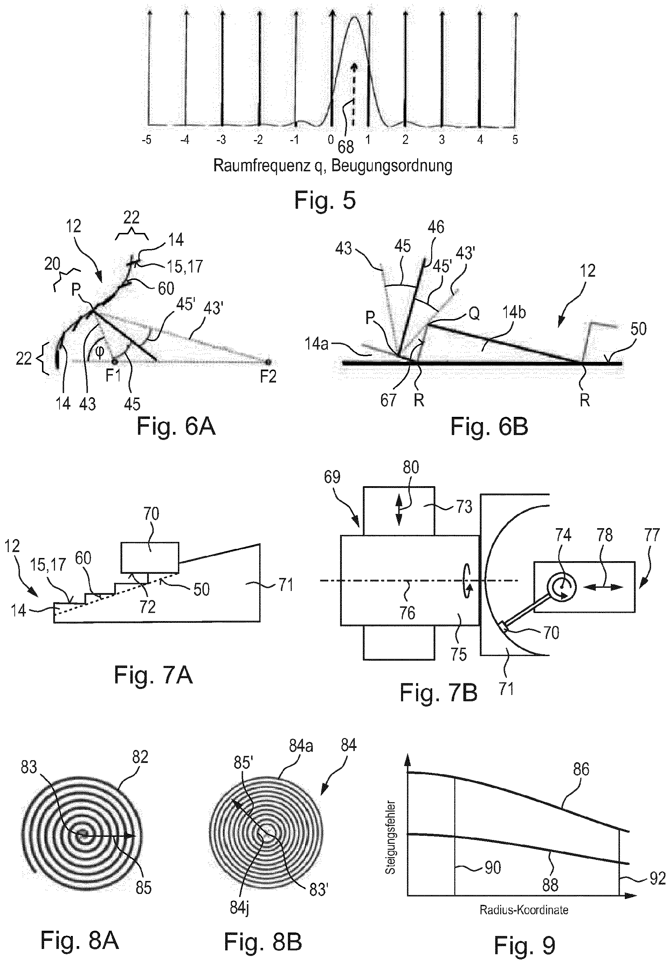

Fig. 5 zeigt ein schematisches Diagramm einer Intensitätsverteilung reflektierter Nutzstrahlen und gebeugter Reststrahlen verschiedener Beugungsordnungen im Fernfeld in Abhängigkeit von der Raumfrequenz q. In einer Raumrichtung 68, in der der spektrale Facettenreflex verläuft, nimmt die Intensität im Fernfeld ihr Maximum an, wobei die Intensitätsverteilung um die Raumrichtung 68 im Wesentlichen spiegelsymmetrisch ist. Ausgehend von der Raumrichtung 68 klingt die Intensität ab, wobei es bei ganzzahligen Raumfrequenzen q=0,

$\pm 1$, $\pm 2$, $\pm 3$, ... etc., die diskreten Raumrichtungen entsprechen, die gebeugten Reststrahlen sich konstruktiv überlagern und sich in diesen diskreten Raumrichtungen Beugungsmaxima ergeben. Die Intensität und Position der Beugungsmaxima sind, außer für die Beugungsordnung 0, von der Wellenlänge der Reststrahlen abhängig. Des Weiteren nimmt die Intensität des gebeugten Reststrahls mit steigender Beugungsordnung, d.h. in Fig. 5 von der Raumfrequenz q=0 ausgehend nach links bzw. nach rechts, monoton und drastisch ab.

Um den gebeugten Reststrahl möglichst vom spekularen Reflex zu trennen, ist es zunächst wünschenswert, wenn der spekulare Facettenreflex möglichst mittig zwischen den gebeugten Reststrahlen der Beugungsordnungen 0 und 1 verläuft, da diese beiden Beugungsordnungen, wie in Fig. 5 gezeigt, die höchsten Intensitätswerte unter den Beugungsordnungen des Reststrahls aufweisen. Außerdem ist es vorteilhaft, wenn die Intensität des gebeugten Reststrahls innerhalb von wenigen Beugungsordnungen um die Raumrichtung 68 des spekularen Facettenreflexes auf zumindest annähernd 0 abklingt. Dies lässt sich durch eine entsprechende Wahl des Blazegitters 12, beispielsweise mit einem Spaltenfüllgrad von etwa eins, erreichen. Der Spaltenfüllgrad ist ein Maß für die Beugungseffizienz eines Beugungsgitters. Für die Beugungseffizienz I(q) des reflektierten Nutzstrahls und des gebeugten Reststrahls verschiedener Beugungsordnungen in Abhängigkeit von der Raumfrequenz q gilt im Fernfeld:

$$I(q) = sinc(\pi^* \sigma^* (q-\Theta))^2 \quad (4)$$

Hierbei ist $\sigma$ der Spaltenfüllgrad und $\theta$ ist die Raumfrequenz des spekularen Reflexes. $\theta$ hängt üblicherweise von der Wellenlänge des Nutzstrahls ab. In der EUV-Mikrolithografie, bei dem das EUV-Licht mit einer Wellenlänge von 13,5 nm als Nutzstrahlen eingesetzt wird, ist $\theta$ daher eine feste Größe. $\sigma$ kann zwischen 0 und 1 variieren, wobei bei $\sigma \sim 1$ die Intensität des gebeugten Reststrahls innerhalb zwei oder drei Beugungsordnungen um die Raumrichtung 68 des spekularen Facettenreflexes auf zumindest annähernd 0 abklingt. Dies begünstigt vorteilhafterweise eine effiziente Unterdrückung von Reststrahlen und ermöglicht eine Fokussierung des EUV-Lichts mit homogener Fernfeld-Intensitätsverteilung und hoher Reinheit.

Die Stufenhöhe 62, die Facettenlänge 64 sowie der Blazewinkel 60 in Fig. 4 sind lokale Größen, die vom Winkel φ zwischen der Strahleinfallsrichtung und der optischen Achse OA abhängen, wobei die Strahleinfallsrichtung durch den ersten Brennpunkt F1 und den Strahleinfallspunkt P definiert ist. Diese drei Größen sind bei kleinen Blazewinkeln 60 näherungsweise durch $\alpha(\varphi)=h(\varphi)/l(\varphi)$ miteinander verknüpft, wobei $\alpha(\varphi)$ den Blazewinkelverlauf, $l(\varphi)$ den Facettenlängenverlauf und $h(\varphi)$ den Stufenhöhenverlauf beschreibt. Dies bedeutet, zwei der drei obigen Größen können beliebig variieren, während die dritte Größe festgelegt ist.

Beispielsweise kann der Blazewinkelverlauf $\alpha(\varphi)$, wie in Fig. 6A schematisch gezeigt, festgelegt werden. Dort nimmt der Blazewinkel 60 vom Randbereich 22 zum Scheitelbereich 20 hin zu, so dass der Abbildungsmaßstab entlang der Spiegelfläche 17 nur schwach variiert. Die Vergrößerung der Einhüllenden der Etendue wird hierdurch reduziert. Vorzugsweise wird der Blazewinkel 60 aus einem Bereich von 1 mrad bis 100 mrad gewählt.

Durch Festlegen des Blazewinkelverlaufs $\alpha(\varphi)$ ist auch die lokale Formabweichung der Spiegelfläche 17 des Blazegitters 12 von einer elliptischen Spiegelfläche festgelegt. Damit ist der lokale Strahleinfallswinkel 45 bzw. die Richtung des spekularen Facettenreflexes für jede Spiegelfacette 14 und somit auch die Grundform der Oberfläche des Blazegitters 12 festgelegt.

Alternativ kann der Facettenlängenverlauf $l(\varphi)$ festgelegt werden, wodurch die Richtungen, in die die gebeugten Reststrahlen höherer wellenlängenabhängiger Beugungsordnungen verlaufen, festgelegt sind. Für kurzwellige Nutzstrahlen 43 kann die Facettenlänge 64 hinreichend groß, vorzugsweise im Bereich $l(\varphi) > 10 \mu m$ gewählt sein, so dass Beugungseffekte des EUV-Lichts weitgehend vernachlässigt werden können. Es kann zusätzlich der Stufenhöhenverlauf $h(\varphi)$ zumindest teilweise festgelegt werden, um Beugungseffekte des Nutzstrahls 43 zusätzlich zu unterdrücken.

Damit jedoch die Beugungseffekte für langwellige Reststrahlen nicht vernachlässigt werden können, wird die Facettenlänge 64 hinreichend klein, vorzugsweise im Bereich $l(\varphi) < 200 \mu m$ gewählt. Somit ergeben sich mehrere Ausfallsrichtungen für den gebeugten Reststrahl, so dass die Wahrscheinlichkeit, dass der gebeugte Reststrahl in derselben Richtung wie der spekulare Reflex 43' auf den zweiten Brennpunkt F2 fokussiert wird, reduziert ist. Außerdem kann in diesem Fall mit Spiegelfacetten 14 mit einem Brennweitenkehrwert, der zumindest annähernd 0 ist, gearbeitet werden. Dies entspricht einer nahezu planen Facettenfläche 15, die besonders einfach und mit hoher Qualität hinsichtlich minimaler Oberflächenrauheit und Steigungsfehler herstellbar ist.

Außerdem kann eine maximale Facettenlänge lmax in Abhängigkeit von der minimalen Wellenlänge $\lambda min$ des IR-Spektralbereichs gewählt werden, um das hoch intensive IR-Licht möglichst effektiv zu unterdrücken. Beispielsweise kann $\lambda$-min einen der folgenden Werte annehmen: 10 $\mu m$, 1 $\mu m$, 200 nm, wobei die zugehörige maximale Facettenlänge lmax jeweils 1000 $\mu m$, 100 $\mu m$ bzw. 20 $\mu m$ beträgt. Diese drei Beispiele beziehen sich auf eine Brennweite von 0,5 m, einen Blendenradius von 1 mm sowie einen Ablenkwinkel von 5 mrad zwischen dem spekularen Facettenreflex und dem gebeugten Reststrahl unter der Beugungsordnung null.

Fig. 6B zeigt illustrativ den Abschattungseffekt zweier benachbarter Spiegelfacetten 14a,b des Blazegitters 12. Der einfallende Nutzstrahl 43 wird an der Facettenfläche 15 der ersten Spiegelfacette 14a reflektiert, wobei der spekulare Facettenreflex 43' in einer Richtung verläuft, die durch den Strahleinfallspunkt P und einen Eckpunkt Q der zweiten Spiegelfacette 14b definiert ist. Der Bereich der Facettenfläche 15 der ersten Spiegelfacette 14a zwischen dem Strahleinfallspunkt P und dem Anschlusspunkt R wird somit abgeschattet, da von diesem Bereich ausgehende spekulare Facettenreflexe 43' durch eine Seitenfläche 67 der zweiten Spiegelfacette 14b blockiert werden. Die Länge des Abschattungsbereichs in der hier gezeigten Darstellung ergibt sich aus der Länge der Seitenfläche 67 multipliziert mit dem Tangens des Nutzstrahleinfallswinkels 45.

Das Blazegitter 12 des Kollektorspiegels 10 ist vorzugsweise mittels eines in Fig. 7A, B illustrativ gezeigten Ultrapräzisionsdrehverfahrens (UP-Drehverfahren) hergestellt. Dabei wird eine UP-Drehanlage 69 eingesetzt, die einen Grundkörper 73, einen am Grundkörper 73 montierten Drehkörper 75 und eine Strukturierungseinheit 77 aufweist. Der Drehkörper 75 ist um eine Spindelachse 76 drehbar. Ein Gitterwerkstück 71 wird am Drehkörper 75 festgelegt. Das Gitterwerkstück 71 weist vorzugsweise eine amorphe spanbare Schicht auf, die beispielsweise Nickel-Phosphor (NiP) und/oder Oxygen-Free-High-Conductivity-Copper (OFHC-Cu) enthält. Die Strukturierungseinheit 77 weist ein spanabhebendes Werkzeug 70, beispielsweise ein Diamantwerkzeug, auf, das eine Druckseite 72 aufweist. Die Strukturierungseinheit 77 ist parallel zur Spindelachse 76 in beiden Richtungen verfahrbar, wie der Doppelpfeil 78 andeutet. Des Weiteren ist das Werkzeug 70 um eine Maschinenachse 74, die in der hier gezeigten Darstellung senkrecht zur Papierebene steht, im Uhrzeigersinn und/oder im Gegenuhrzeigersinn drehbar. Die Druckseite 72 ist plan und/oder gewölbt ausgebildet. Der Drehkörper 75 ist am Grundkörper 73 höhenverstellbar, was durch den Doppelpfeil 80 angedeutet ist.

Fig. 8A zeigt eine schematisierte Spiralbahn 82, die um eine Achse 83, die senkrecht zur Zeichenebene verläuft, spiralförmig ausgebildet ist. Die Spiralbahn 82 ist in Fig. 8A in einer Ansicht entlang der Achse 83 gezeigt, wobei sich die Spiralbahn 82 räumlich betrachtet entlang der Achse 83 mit zunehmendem Bahnradius 85 in Richtung aus der Zeichenebene kontinuierlich herauserstreckt. Fig. 8B zeigt eine schematisierte Bahnanordnung 84 aus bezüglich einer Achse 83' konzentrischen Kreisbahnen 84a-j. Analog zu Fig. 8A sind die Kreisbahnen 84a-j in Fig. 8B in einer Ansicht entlang der Achse 83' gezeigt, wobei die Kreisbahnen 84a-j räumlich betrachtet mit zunehmenden Bahnradius 85' in Richtung aus der Zeichenebene herausstreckt.

Zur Strukturierung des Gitterwerkstücks 71 wird dieses zunächst am Drehkörper 75 der UP-Drehanlage 69 befestigt. Danach wird das Werkzeug 70 zu einer gewünschten Stellung relativ zum Gitterwerkstück 71 gebracht, die der gewünschten Oberflächenform der zu bildenden Facettenfläche 15 entspricht. Danach wird das Gitterwerkstück 71 mit Hilfe des Drehkörpers 75 relativ zum Werkzeug 70 entlang der Spiralbahn 82 (Fig. 8A) und/oder der Bahnanordnung 84 (Fig. 8B) verfahren, wobei die zum Verfahren entlang der Spiralbahn 82 und der Bahnanordnung 84 erforderliche relative Drehbewegung mittels Drehens des Drehkörpers 75 um die Spindelachse 76 bewerkstelligt wird.

Beim Abfahren der Spiralbahn 82 findet eine kontinuierliche Bewegung zwischen dem Werkzeug 70 und dem Gitterwerkstück 71 statt, wobei das Werkzeug 70 mit dem Gitterwerkstück 71 ständig im Eingriff ist. Beim Strukturieren gemäß der Bahnanordnung 84 aus konzentrischen Kreisen 84a-j wird das Werkzeug 70 abwechselnd in die Oberfläche des Gitterwerkstücks 71 eingetaucht und abgehoben.

Nachdem die Spiralbahn 82 bzw. die Bahnanordnung 84 vollständig abgefahren ist, erhält die Spiegelfläche 17 des Blazegitters 12 ihren gewünschten Verlauf. Dies bedeutet, dass der Verlauf des Blazewinkels 60 festgelegt ist. Das hierdurch hergestellte Blazegitter 12 ist um die Spindelachse 76 zumindest abschnittsweise rotationssymmetrisch.

Die Druckseite 72 des Werkzeugs 70 weist eine plane Oberfläche auf, was im Hinblick auf das Reduzieren der Kantenverrundung besonders vorteilhaft ist, da bei einer planen Druckseite 72 die Kantenverrundung selbst bei großen Stufenhöhen verschwindend klein ist. Es kommt dadurch zu einer Erhöhung der Nutzstrahlentransmission um bis zu 10%. Außerdem ist der Bahnabstand, d.h. die Abmessung der Kontaktfläche zwischen der Druckseite 72 und dem Gitterwerkstück 71, aufgrund der planen Druckseite 72 deutlich vergrößert, so dass die für das Strukturieren des gesamten Blazegitters 12 erforderliche Anzahl der Dreh- und Spanvorgänge reduziert ist. Dadurch wird die Bearbeitungszeit und/oder Abnutzung des Werkzeugs 70 vorteilhafterweise reduziert. Der Einfluss von Vibrationen des Werkzeugs 70 auf die Oberflächenrauheit ist vernachlässigbar. Eine maximale Oberflächenrauheit im Bereich von 1nm bis 2 nm ist mit Hilfe des DP-Drehverfahrens realisierbar. Ferner ist aufgrund der kleinen Bahnabstände der laterale Versatz des zweiten Brennpunktes F2 beim Verfahren der Spiralbahn 82 vernachlässigbar.

Ein weiterer Vorteil, der sich aus einer planen Druckseite 72 ergibt, besteht in einem deutlich verringerten Steigungsfehler der Spiegelfacetten 14. Unter Verwendung der planen Druckseite 72 können Facettenflächen 15 realisiert werden, deren maximaler Steigungsfehler im Wesentlichen proportional zur Facettenlänge 64 ist. Dies bedeutet, bei der Wahl einer hinreichend kleinen Facettenlänge 64 können andere Effekte, die zum Steigungsfehler beitragen, unterdrückt werden. Fig. 9 zeigt ein schematisches Diagramm, in dem ein maximaler Steigungsfehler 86 und ein mittlerer Steigungsfehler 88 als Funktion einer Radius-Koordinate des Radius 85, 85' der Spiralbahn 82 bzw. der Bahnanordnung 84 aufgetragen ist. Die Radius-Koordinate variiert zwischen einem minimalen Radius 90 und einem minimalen Radius 92. Bei einer Facettenlänge 64 von 100 $\mu$m wird der maximale Steigungsfehler aufgrund der planen Druckseite 72 um 90% gegenüber den aus dem Stand der Technik bekannten Kollektorspiegeln reduziert.

Vorzugsweise sind die Spiegelfacetten 14 und/oder die Facettenflächen 15 jeweils mittels eines einzigen Spanvorgangs gebildet, bei dem die Facettenfläche 15 von der dem Gitterwerkstück 71 zugewandten Druckseite 72 des Werkzeugs 70 erfasst wird. Somit ergeben sich die einzelnen Spiegelfacetten 14 und/oder die einzelnen Facettenflächen 15 als "Abbild" der Druckseite 72. Die Bearbeitungszeit lässt sich dadurch vorteilhafterweise weiter reduzieren.

Um die Oberflächenrauheit der Spiegelfacetten 14 zu minimieren wird gemäß einem Ausführungsbeispiel im Anschluss an das UP-Drehverfahren das vorstrukturierte Gitterwerkstück 71 in einem Glättprozess geglättet. Vorzugsweise wird ein nicht-mechanisches Glätten, bspw. Ionenstrahlglätten und/oder Flüssigfilm-Glätten. Das Ionenstrahlglätten ist aus der Publikation Frost et al., "Large area smoothing of surfaces by ion bombardment: fundamentals and applications, J. Phys.: Condens. Matter 21, 22, 224026" bekannt. Das Flüssigfilm-Glätten ist aus der Patentanmeldung US2014/0118830A1 bekannt. Eine reduzierte Verrundung der Gitterstruktur kann hiermit vorteilhafterweise erzielt werden.

Zur Verbesserung der Reflexionseigenschaften der Spiegelfläche 17 wird die im Glättprozess oberflächenverarbeitete Seite des Gitterwerkstücks 71 mit einem Schichtstapel aus mehreren alternierenden Einzelschichten aus Molybdän und Silizium überbeschichtet sind, wobei eine Schichtdicke der Einzelschichten in Abhängigkeit von einem lokalen Strahleinfallswinkel in Bezug auf die einzelnen Facettenflächen gewählt ist. Eine derartige MoSi-Stapelschicht ist vorteilhaft, da jede Spiegelfacette 14 in ihren Reflexionseigenschaften auf ihren gewünschten lokalen Strahleinfallswinkel individuell optimiert ist. Die Spiegelfläche 17 fokussiert das EUV-Licht an der Spiegelfläche 17 vorteilhafterweise gleichmäßig und präzise auf den zweiten Brennpunkt F2. Vorzugsweise wird die strukturierte Seite des Gitterwerkstücks vor und/oder nach dem Aufbringen der MoSi-Stapelschicht mit einem Material überbeschichtet, wobei das Material Aluminium und/oder einen dielektrischen Schutz, bspw. MgF2, aufweist. Diese schützt die Spiegelfläche 17 des Blazegitters 12 zusätzlich vor Degradierungseffekten.

Das Blazegitter 12 weist vorzugsweise eine Root-Mean-Square (RMS)-Mikrorauheit im Bereich von 0 bis 0,2 nm auf, wobei eine Obergrenze von 0,2 nm etwa 1/80 der EUV-Wellenlänge entspricht. Hierdurch kann vorteilhafterweise ein Streulichtverlust des EUV-Lichtes auf maximal 2,5% reduziert werden. Weiter vorzugsweise weist der Kollektorspiegel 10 zumindest eine Antiblaze-Facette mit einem Neigungswinkel von mindestens 25° auf.

Es versteht sich, dass der Kollektorspiegel 10 nicht nur für EUV-Mikrolithografie mit einer Wellenlänge von 13,5 nm, sondern auch für mikrolithografische Anwendungen geeignet ist, bei denen Belichtungslicht mit einer anderen Wellenlänge, beispielsweise bis 400 nm, vorzugsweise bis 200 nm, verwendet werden kann.

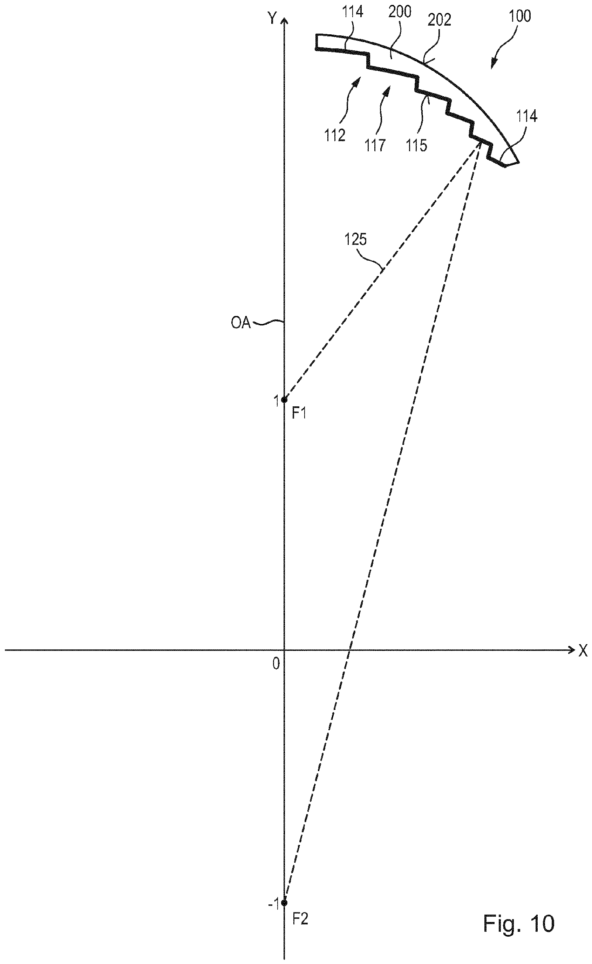

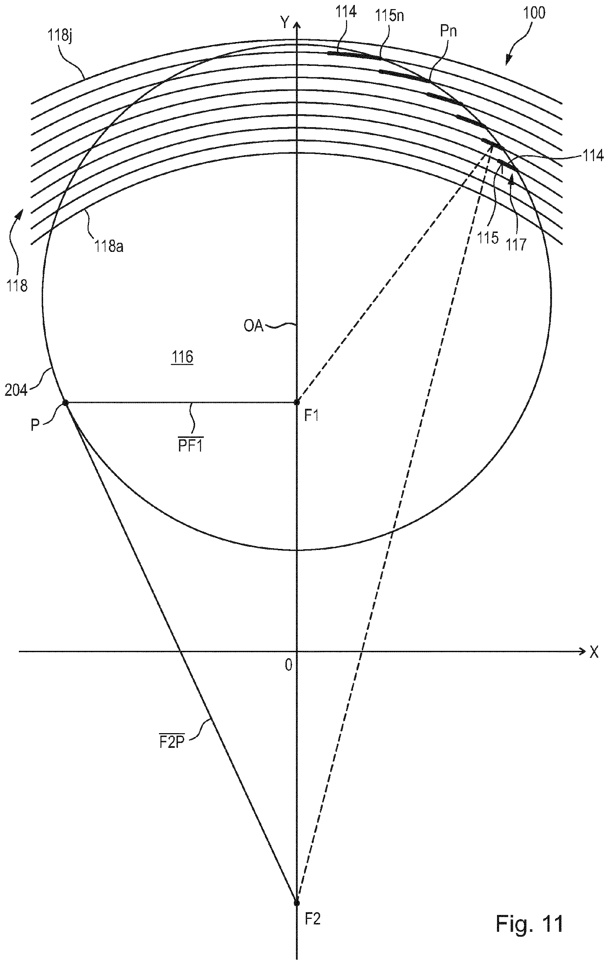

Mit Bezug auf Fig. 10 und 11 wird ein weiteres Ausführungsbeispiel eines Spiegels 100 beschrieben. Elemente des Spiegels 100, die mit Elementen des Ausführungsbeispiels in Fig. 1 identisch, ähnlich oder vergleichbar sind, sind mit um 100 erhöhten Bezugszeichen versehen. Soweit nachfolgend nicht anders beschrieben, gilt die obige Beschreibung auch in Bezug auf den Spiegel 100.

Gemäß Fig. 10 weist der Spiegel 100 ein optisches Gitter 112 auf, das eine optisch wirksame Spiegelfläche 117 aufweist, die elektromagnetische Strahlung 125, die von einem ersten Brennpunkt F1 ausgeht, in einen zweiten Brennpunkt F2 fokussiert. Die Brennpunkte F1 und F2 definieren die optische Achse OA. Das optische Gitter 112 weist eine Mehrzahl von Spiegelfacetten 114 auf, die jeweils eine Facettenfläche 115 aufweisen, wobei die Facettenflächen 115 die Spiegelfläche 117 des optischen Gitters 112 bilden.

Auf seiner Rückseite weist der Spiegel 100 ein Substrat 200 auf.

Gemäß Fig. 11 sind die Facettenflächen 115 wie bei dem Kollektorspiegel 10 in einer die optische Achse OA umfassenden Schnittebene 116 auf mehreren gedachten, entlang der optischen Achse OA voneinander verschobenen Ellipsenschalen 118a-j einer Ellipsenschar 118 angeordnet. Die einzelnen Facettenflächen 115 genügen jedoch zusätzlich einer weiteren Anordnungsvorschrift, die nachfolgend beschrieben wird.

In Fig. 11 ist eine gedachte Kreislinie 204 eingezeichnet, die durch die Menge k aller Punkte P gegeben ist, für die gilt:

$$\mathrm{k} = \left\{ \mathrm{P} \mid \overline{F2P} : \overline{PF1} = \lambda \right\} \qquad (5)$$

wobei $\lambda$ eine Konstante ist. Die Kreislinie bzw. der Kreis 204 wird auch als Appoloniuskreis bezeichnet. Das Verhältnis aus dem Abstand von Brennpunkt F2 zu dem jeweiligen Punkt P und dem Abstand des Punktes P zu dem Brennpunkt F1 ist somit für alle Punkte P auf der Kreislinie 204 gleich dem festen Wert $\lambda$.

Die Facettenflächen 115 sind nun auf die Ellipsenschalen 118a-j der Ellipsenschar 118 so verteilt, dass die Facettenflächen 115 an Schnittpunkten Pn der Ellipsenschalen 118a-j mit zumindest einem Abschnitt der gedachten Kreislinie 204 angeordnet sind. Damit sind die Abbildungsmaßstäbe der einzelnen Spiegelfacetten 114 untereinander zumindest näherungsweise gleich. Der Spiegel 100 weist somit über seine Spiegelfläche 117 gesehen einen konstanten Abbildungsmaßstab auf, das heißt der Brennpunkt F1 wird vorliegend von allen Spiegelfacetten 114 auf den Brennpunkt F2 fokussiert. In dem Brennpunkt F2 entsteht somit ein scharfes Bild bzw. Zwischenbild.

In dem gezeigten Ausführungsbeispiel gemäß Fig. 11 sind Fußpunkte 115n der Facettenflächen 115 an den Schnittpunkten Pn der Kreislinie 204 mit den Ellipsenschalen 118a-j angeordnet.

Der Spiegel 100 weist nicht nur über seine Spiegelfläche 117 gesehen einen konstanten Abbildungsmaßstab auf, sondern eine Oberfläche 202 des Substrats 200 kann insbesondere sphärisch ausgebildet sein, was die Fertigung deutlich vereinfacht. Die Spiegelfläche 117 ist im Unterschied zu der Spiegelfläche 17 nicht durchgebeult, sondern sphärisch.

Des Weiteren ist die Spiegelfläche 117 des Spiegels 100 in dem gezeigten Ausführungsbeispiel vollständig außerhalb der optischen Achse OA angeordnet. Der Spiegel 100 wird somit "off-axis" betrieben. Das optische Gitter 112 ist vorzugsweise ein Blazegitter, kann jedoch auch eine Fresnelstruktur sein.

Der Kollektorspiegel 10 in Fig. 1 kann ebenfalls so ausgestaltet sein, dass die Facettenflächen 15 wie bei dem Spiegel 100 an Schnittpunkten eines Appoloniuskreises mit den Ellipsenschalen 18a-j angeordnet sind. Es ist also möglich, eine Spiegelkonstruktion wie bei dem Spiegel 100 auch für einen Kollektorspiegel anzuwenden. In diesem Fall sind die einzelnen Spiegelfacetten 114 zumindest abschnittsweise rotationssymmetrisch um die optische Achse OA ausgebildet.

Der Spiegel 100, insbesondere in der "off-axis"-Ausgestaltung gemäß Fig. 10, kann als Abbildungsspiegel innerhalb eines optischen Systems, beispielsweise eines EUV-Mikrolithographiesystems, oder eines optischen UV-Systems eingesetzt werden.

**Patentansprüche**

1. Spiegel, der ein optisches Gitter (112) mit einer optisch wirksamen Spiegelfläche (117) aufweist, die elektromagnetische Strahlen, die von einem ersten Brennpunkt (F1) ausgehen, reflektiert und auf einen zweiten Brennpunkt (F2) fokussiert, wobei der erste und der zweite Brennpunkt (F1, F2) auf einer der Spiegelfläche (117) zugewandten Seite des optischen Gitters (112) liegen und eine optische Achse (OA) definieren, wobei das optische Gitter (112) eine Mehrzahl von Spiegelfacetten (114) aufweist, die jeweils eine Facettenfläche (115) aufweisen, wobei die Facettenflächen (115) die Spiegelfläche des Gitters (112) bilden, wobei die Facettenflächen (115) in einer die optische Achse (OA) umfassenden Schnittebene (116) auf mehreren gedachten, entlang der optischen Achse (OA) voneinander verschobenen Ellipsenschalen (118a-j) angeordnet sind, deren gemeinsame mathematischen Fokuspunkte mit dem ersten und dem zweiten Brennpunkt (F1, F2) zusammenfallen, **dadurch gekennzeichnet, dass** die Facettenflächen (115) auf die Ellipsenschalen (118a-j) so verteilt sind, dass die Facettenflächen (115) an Schnittpunkten (Pn) der Ellipsenschalen (118a-j) mit zumindest einem Abschnitt einer gedachten Kreislinie (204) angeordnet sind, wobei für jeden Punkt (P) auf der Kreislinie das Verhältnis aus dem Abstand des ersten Brennpunkts zum Punkt (P) und dem Abstand des Punktes (P) zum zweiten Brennpunkt den gleichen Wert hat.

2. Spiegel nach Anspruch 1, **dadurch gekennzeichnet, dass** Fußpunkte (115n) der Spiegelfacetten (115) an den Schnittpunkten (Pn) angeordnet sind.

3. Spiegel nach Anspruch 1 oder 2, **dadurch gekennzeichnet, dass** die Spiegelfläche (117) vollständig außerhalb der optischen Achse (OA) angeordnet ist.

4. Spiegel nach einem der Ansprüche 1 bis 3, **dadurch gekennzeichnet, dass** das optische Gitter (112) ein Blazegitter oder eine Fresnelstruktur ist.

5. Spiegel nach einem der Ansprüche 1 bis 3, **dadurch gekennzeichnet, dass** das optische Gitter (12; 112) dafür ausgelegt ist, um im Zusammenwirken mit einer im zweiten Brennpunkt (F2) angeordneten Blende (38) elektromagnetische Nutzstrahlen (23, 25, 35, 42, 43) eines EUV-Spektralbereichs durch die Blende (38) durchzulassen und elektromagnetische Reststrahlen (36, 47) eines vom EUV-Spektralbereich verschiedenen Restspektralbereichs zu blockieren, wobei das optische Gitter (12; 112) ein Blazegitter aufweist, wobei die Facettenflächen (15; 115) die Spiegelfläche (17; 117) des Blazegitters bilden, wobei sich die Spiegelfläche (17; 117) entlang der gedachten Ellipsenschalen (18a-j; 118a-j) erstreckt, und wobei eine randbereichsseitige Spiegelfacette (14; 114) eines benachbarten Spiegelfacettenpaares auf einer ersten Ellipsenschale (18a-j; 118a-j) angeordnet ist, wobei eine scheitelbereichsseitige Spiegelfacette (14; 114) des Spiegelfacettenpaares auf einer zur ersten Ellipsenschale (18a-j; 118a-j) benachbarten zweiten Ellipsenschale (18a-j; 118a-j) angeordnet ist, wobei die erste Ellipsenschale (18a-j; 118a-j) entlang der optischen Achse (OA) von der zweiten Ellipsenschale (18a-j; 118a-j) zum ersten Brennpunkt (F1) hin verschoben ist.

6. Spiegel nach Anspruch 5, **dadurch gekennzeichnet, dass** das Blazegitter (12) einen Blazewinkel (60) aufweist, um den die Facettenflächen (15) jeweils lokal gegen eine Gitteroberfläche (50) geneigt sind, wobei der Blazewinkel (60) vom Randbereich (22) zu einem Scheitelbereich (20) hin steigt.

7. Spiegel nach Anspruch 5 oder 6, **dadurch gekennzeichnet, dass** das Blazegitter (12; 112) ein Beugungsgitter zum Beugen der Reststrahlen (36, 47) aufweist, wobei die an der Spiegelfläche (17; 117) reflektierten Nutzstrahlen (23, 25, 35, 42, 43) um zumindest das Zweifache des Blazewinkels (60) von den gebeugten Reststrahlen (47') der nullten Beugungsordnung abgelenkt und/oder zwischen den gebeugten Reststrahlen (47', 51) der nullten und der ersten Beugungsordnung verlaufen.

8. Spiegel nach Anspruch 7, **dadurch gekennzeichnet, dass** der Restspektralbereich einen infraroten Spektralbereich umfasst, wobei die nullte und die erste Beugungsordnung auf die gebeugten Reststrahlen (47', 51) einer minimalen Wellenlänge des Restspektralbereichs bezogen sind.

9. Spiegel nach einem der Ansprüche 1 bis 8, **dadurch gekennzeichnet, dass** auf den Ellipsenschalen (18a-j; 118a-j) jeweils nur eine Facettenfläche (15; 115) angeordnet ist.

10. Spiegel nach einem der Ansprüche 1 bis 9, **dadurch gekennzeichnet, dass** die Ellipsenschalen (18a-j; 118a-j) entlang der optischen Achse (OA) im Wesentlichen äquidistant voneinander beabstandet sind.

11. Spiegel nach einem der Ansprüche 1 bis 10, **dadurch gekennzeichnet, dass** zumindest zwei Spiegelfacetten (14) einen Brennweitenkehrwert von zumindest annähernd 0 aufweisen, oder dass die zumindest zwei Spiegelfacetten (14; 114) einen gleichen Brennweitenkehrwert aufweisen.

12. Spiegel nach einem der Ansprüche 1 bis 11, **dadurch gekennzeichnet, dass** die Facettenflächen (15) in der Schnittebene (16) jeweils eine Facettenlänge (64) aufweisen, wobei zumindest zwei Facettenlängen (64) verschieden sind und/oder die Facettenlänge (64) eine maximale Facettenlänge nicht überschreitet, die in Abhängigkeit von einer minimalen Wellenlänge (Amin) des Restspektralbereichs gewählt ist.

13. Spiegel nach Anspruch 12, **dadurch gekennzeichnet, dass** die Facettenlänge (64) im Bereich von 10 $\mu$m bis 200 $\mu$m liegt.

14. Spiegel nach einem der Ansprüche 1 bis 13, **dadurch gekennzeichnet, dass** das Blazegitter (12) eine Oberflächenrauheit im Bereich von 0 bis 0,2 nm aufweist.

15. Spiegel nach einem der Ansprüche 1 bis 14, **dadurch gekennzeichnet, dass** der Spiegel ein Kollektorspiegel für ein EUV Mikrolithografiesystem ist.

**Claims**

1. Mirror comprising an optical grating (112) having an optically effective mirror surface (117), which reflects electromagnetic rays emanating from a first focal point (F1) and focuses them onto a second focal point (F2), wherein the first and the second focal points (F1, F2) lie on a side of the optical grating (112) facing the mirror surface (117) and define an optical axis (OA), wherein the optical grating (112) comprises a plurality of mirror facets (114) each having a facet surface (115), wherein the facet surfaces (115) form the mirror surface of the grating (112), wherein the facet surfaces (115), in a sectional plane (116) comprising the optical axis (OA), are arranged on a plurality of imaginary elliptical shells (118a-j) which are displaced from one another along the optical axis (OA) and the common mathematical focus points of which coincide with the first and the second focal points (F1, F2), **characterized in that** the facet surfaces (115) are distributed along the elliptical shells (118a-j) such that the facet surfaces (115) are arranged at intersection points (Pn) of the elliptical shells (118a-j) with at least one section of an imaginary circular line (204), wherein for each point (P) on the circular line the ratio of the distance from the first focal point to the point (P) and the distance from the point (P) to the second focal point has the same value.

2. Mirror according to Claim 1, **characterized in that** base points (115n) of the mirror facets (115) are arranged at the intersection points (Pn).

3. Mirror according to Claim 1 or 2, **characterized in that** the mirror surface (117) is arranged completely outside the optical axis (OA).

4. Mirror according to any of Claims 1 to 3, **characterized in that** the optical grating (112) is a blazed grating or a Fresnel structure.

5. Mirror according to any of Claims 1 to 3, **characterized in that** the optical grating (12; 112) is designed, in interaction with a stop (38) arranged at the second focal point (F2), to allow electromagnetic used rays (23, 25, 35, 42, 43) of an EUV spectral range to pass through the stop (38) and to block electromagnetic remaining rays (36, 47) in a remaining spectral range different than the EUV spectral range, wherein the optical grating (12; 112) comprises a blazed grating, wherein the facet surfaces (15; 115) form the mirror surface (17; 117) of the blazed grating, wherein the mirror surface (17; 117) extends along the imaginary elliptical shells (18a-j; 118a-j), and wherein a marginal-region-side mirror facet (14; 114) of an adjacent mirror facet pair is arranged on a first elliptical shell (18a-j; 118a-j), wherein a vertex-region-side mirror facet (14; 114) of the mirror facet pair is arranged on a second elliptical shell (18a-j; 118a-j) adjacent to the first elliptical shell (18a-j; 118a-j), wherein the first elliptical shell (18a-j; 118a-j) is displaced along the optical axis (OA) from the second elliptical shell (18a-j; 118a-j) toward the first focal point (F1).

6. Mirror according to Claim 5, **characterized in that** the blazed grating (12) has a blaze angle (60) by which the facet surfaces (15) are inclined in each case locally relative to a grating surface (50), wherein the blaze angle (60) increases from the marginal region (22) toward a vertex region (20).

7. Mirror according to Claim 5 or 6, **characterized in that** the blazed grating (12; 112) comprises a diffraction grating for diffracting the remaining rays (36, 47), wherein the used rays (23, 25, 35, 42, 43) reflected at the mirror surface (17; 117) are deflected from the diffracted remaining rays (47') of the zero order of diffraction by at least twice the blaze angle (60) and/or pass between the diffracted remaining rays (47', 51) of the zero and the first orders of diffraction.

8. Mirror according to Claim 7, **characterized in that** the remaining spectral range comprises an infrared spectral range, wherein the zero and the first orders of diffraction are related to the diffracted remaining rays (47', 51) having a minimum wavelength of the remaining spectral range.

9. Mirror according to any of Claims 1 to 8, **characterized in that** in each case only one facet surface (15; 115) is arranged on the elliptical shells (18a-j; 118a-j).

10. Mirror according to any of Claims 1 to 9, **characterized in that** the elliptical shells (18a-j; 118a-j) are spaced apart substantially equidistantly from one another along the optical axis (OA).

11. Mirror according to any of Claims 1 to 10, **characterized in that** at least two mirror facets (14) have a focal length reciprocal value of at least approximately 0, or **in that** the at least two mirror facets (14; 114) have an identical focal length reciprocal value.

12. Mirror according to any of Claims 1 to 11, **characterized in that** the facet surfaces (15) have in the sectional plane (16) in each case a facet length (64), wherein at least two facet lengths (64) are different and/or the facet length (64) does not exceed a maximum facet length chosen depending on a minimum wavelength ($\lambda$min) of the remaining spectral range.

13. Mirror according to Claim 12, **characterized in that** the facet length (64) is in the range of 10 $\mu$m to 200 $\mu$m.

14. Mirror according to any of Claims 1 to 13, **characterized in that** the blazed grating (12) has a surface roughness in the range of 0 to 0.2 nm.

15. Mirror according to any of Claims 1 to 14, **characterized in that** the mirror is a collector mirror for an EUV microlithography system.

## Revendications

1. Miroir, lequel possède un réseau de diffraction (112) ayant d'une surface de miroir (117) optiquement active, qui réfléchit les rayons électromagnétiques émanant d'un premier foyer (F1) et les concentre sur un deuxième foyer (F2), les premier et deuxième foyers (F1, F2) se trouvant sur un côté du réseau de diffraction (112) à l'opposé de la surface de miroir (117) et définissant un axe optique (OA), le réseau de diffraction (112) possédant une pluralité de facettes de miroir (114), lesquelles possèdent respectivement une surface de facette (115), les surfaces de facette (115) étant disposées dans un plan de coupe (116) comprenant l'axe optique (OA) sur plusieurs coques elliptiques (118a-j) imaginaires décalées les unes des autres le long de l'axe optique (OA), dont les points de focalisation mathématiques communs coïncident avec les premier et deuxième foyers (F1, F2), **caractérisé en ce que** les surfaces de facette (115) sont distribuées sur les coques elliptiques (118a-j) de telle sorte que les surfaces de facette (115) sont disposées au niveau des points d'intersection (Pn) des coques elliptiques (118a-j) avec au moins une portion d'une ligne circulaire (204) imaginaire, le rapport de l'écart entre le premier foyer et le point (P) par l'écart entre le point (P) et le deuxième foyer ayant la même valeur pour chaque point (P) sur la ligne circulaire.

2. Miroir selon la revendication 1, **caractérisé en ce que** les bases (115n) des facettes de miroir (115) sont disposées au niveau des points d'intersection (Pn).

3. Miroir selon la revendication 1 ou 2, **caractérisé en ce que** la surface de miroir (117) est entièrement disposée en-dehors de l'axe optique (OA).

4. Miroir selon l'une des revendications 1 à 3, **caractérisé en ce que** le réseau de diffraction (112) est un réseau blazé ou une structure de Fresnel.

5. Miroir selon l'une des revendications 1 à 3, **caractérisé en ce que** le réseau de diffraction (12 ; 112) est conçu pour, en coopération avec un obturateur (38) disposé dans le deuxième foyer (F2), laisser passer les rayons utiles électromagnétiques (23, 25, 35, 42, 43) d'une plage spectrale EUV à travers l'obturateur (38) et bloquer les rayons résiduels électromagnétiques (36, 47) d'une plage spectrale résiduelle différente de la plage spectrale EUV, le réseau de diffraction (12 ; 112) possédant un réseau blazé, les surfaces de facette (15 ; 115) formant les surfaces de miroir (17 ; 117) du réseau blazé, les surfaces de miroir (17 ; 117) s'étendant le long des coques elliptiques (18a-j ; 118a-j) imaginaires et une facette de miroir (14 ; 114) côté zone du bord d'une paire de facettes de miroir voisine étant disposée sur une première coque elliptique (18a-j ; 118a-j), une facette de miroir (14 ; 114) côté zone du sommet de la paire de facettes de miroir étant disposée sur une deuxième coque elliptique (18a-j ; 118a-j) voisine de la première coque elliptique (18a-j ; 118a-j), la première coque elliptique (18a-j ; 118a-j) étant décalée de la deuxième coque elliptique (18a-j ; 118a-j) le long de l'axe optique (OA) en direction du premier foyer (F1).

6. Miroir selon la revendication 5, **caractérisé en ce que** le réseau blazé (12) possède un angle de blaze (60) selon lequel les surfaces de facette (15) sont respectivement inclinées localement contre une surface de réseau (50), l'angle de blaze (60) augmentant de la zone de bord (22) vers une zone de sommet (20).

7. Miroir selon la revendication 5 ou 6, **caractérisé en ce que** le réseau blazé (12 ; 112) possède un réseau de diffraction destiné à diffracter les rayons résiduels (36, 47), les rayons utiles (23, 25, 35, 42, 43) réfléchis sur la surface de miroir (17 ; 117) étant déviés d'au moins le double de l'angle de blaze (60) des rayons résiduels diffractés (47') du zérotième ordre de diffraction et/ou s'étendant entre les rayons résiduels diffractés (47', 51) du zérotième et du premier ordre de diffraction.

8. Miroir selon la revendication 7, **caractérisé en ce que** la plage spectrale résiduelle comprend une plage spectrale infrarouge, le zérotième et le premier ordre de diffraction se référant aux rayons résiduels diffractés (47', 51) d'une longueur d'onde minimale de la plage spectrale résiduelle.

9. Miroir selon l'une des revendications 1 à 8, **caractérisé en ce qu'**une seule surface de facette (15 ; 115) est respectivement disposée sur les coques elliptiques (18a-j ; 118a-j).

10. Miroir selon l'une des revendications 1 à 9, **caractérisé en ce que** les coques elliptiques (18a-j ; 118a-j) sont disposées de manière sensiblement équidistante le long de l'axe optique (OA).

11. Miroir selon l'une des revendications 1 à 10, **caractérisé en ce qu'**au moins deux facettes de miroir (14) possèdent un inverse de distance focale au moins approximativement égal à 0, ou **en ce que** les au moins deux facettes de miroir (14) possèdent des inverses de distance focale égaux.

12. Miroir selon l'une des revendications 1 à 11, **caractérisé en ce que** les surfaces de facette (15) possèdent dans le plan de coupe (16) respectivement une longueur de facette (64), au moins deux longueurs de facette (64) étant différentes et/ou la longueur de facette (64) ne dépassant pas une longueur de facette maximale qui est choisie en fonction d'une longueur d'onde minimale ($\lambda$min) de la plage spectrale résiduelle.

13. Miroir selon la revendication 12, **caractérisé en ce que** la longueur de facette (64) est comprise dans la plage de 10 $\mu$m à 200 $\mu$m.

14. Miroir selon l'une des revendications 1 à 13, **caractérisé en ce que** le réseau blazé (12) possède une rugosité de surface dans la plage de 0 à 0,2 nm.

15. Miroir selon l'une des revendications 1 à 14, **caractérisé en ce que** le miroir est un miroir collecteur pour un système de microlithographie EUV.

Fig. 1

Fig. 2

Fig. 3A

Fig. 3B

Fig. 4

Fig. 5

Fig. 6A

Fig. 6B

Fig. 7A

Fig. 7B

Fig. 8A

Fig. 8B

Fig. 9

Fig. 10

Fig. 11

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102014117453
- WO 2014170093 A2
- DE 102009044462 A1
- DE 102010063530 A1
- US 20090289205 A1
- DE 102013002064 A1
- US 20140118830 A1

**In der Beschreibung aufgeführte Nicht-Patentliteratur**

- **FROST et al.** Large area smoothing of surfaces by ion bombardment: fundamentals and applications. *J. Phys.: Condens. Matter,* vol. 21, 22, 224026